(19) Europäisches Patentamt
European Patent Office
Office européen des brevets

(11) **EP 4 761 016 A1**

(12) **EUROPEAN PATENT APPLICATION**
published in accordance with Art. 153(4) EPC

(43) Date of publication:
**17.06.2026 Bulletin 2026/25**

(51) International Patent Classification (IPC):
*H01S 5/183* (2006.01)

(21) Application number: **24899410.5**

(86) International application number:
**PCT/CN2024/119571**

(22) Date of filing: **19.09.2024**

(87) International publication number:
**WO 2025/118764 (12.06.2025 Gazette 2025/24)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **08.12.2023 US 202363607776 P
25.04.2024 CN 202410506933**

(71) Applicant: **Vertilite Co., Ltd.
Changzhou, Jiangsu 213000 (CN)**

(72) Inventors:
• **LIANG, Dong
Changzhou, Jiangsu 213000 (CN)**
• **ZHANG, Cheng
Changzhou, Jiangsu 213000 (CN)**

(74) Representative: **HGF
HGF Europe LLP
4th Floor, 1 City Square
Leeds LS1 2ES (GB)**

(54) **ANTIREFLECTIVE VERTICAL-CAVITY SURFACE-EMITTING LASER AND CHIP**

(57) An antireflective vertical-cavity surface-emitting laser and chip are provided. The laser includes: an active region (30) as well as a lower Bragg reflector layer (10) and an upper Bragg reflector layer (20) located on opposite sides of the active region (30). The active region (30) includes at least five active layers (310) and tunnel junctions (330) located between the active layers (310). An antireflective light storage cavity (40) is provided at at least one of a region between the lower Bragg reflector layer (10) and the active region (30), or a region between the upper Bragg reflector layer (20) and the active region (30). The antireflective light storage cavity (40) is configured to increase the peak light field intensity to be higher than the peak light field intensity of the active region (30) and to store light field energy. The antireflective vertical-cavity surface-emitting laser operates under conditions of an injection current density greater than 10 kA/cm$^2$, a slope efficiency greater than 4 W/A, and a far-field divergence angle less than or equal to 19°.

FIG. 1

## Description

This application claims priority to U.S. provisional patent application No. 63/607,776 filed on Dec. 8, 2023, titled "ANTIREFLECTIVE VERTICAL-CAVITY SURFACE-EMITTING LASER", and priority to Chinese Patent Application No. 202410506933.1 filed with the China National Intellectual Property Administration (CNIPA) on Apr. 25, 2024, the disclosures of which are incorporated herein by reference in their entireties.

## TECHNICAL FIELD

The present application relates to the technical field of semiconductor laser devices, for example, to an antireflective vertical-cavity surface-emitting laser and an antireflective vertical-cavity surface-emitting laser chip.

## BACKGROUND

Multi-junction vertical-cavity surface-emitting lasers (VCSEL) are becoming increasingly popular in automotive LiDARs, but the divergence angles of conventional VCSELs generally range from 20° to 30°, which are quite large for most medium-range and long-range scanning LiDARs.

The conventional method to reduce the VCSEL beam divergence angle is to extend the cavity length with an extended cavity layer, thereby reducing the contrast of the effective refraction index between the inside and outside of the VCSEL's optical aperture and suppressing the generation of high-order transverse modes. However, after the cavity of the VCSEL is lengthened, the spacing of the laser longitudinal modes will also decrease, and multiple longitudinal modes, that is, multiple spectral peaks, will appear in the emission spectrum of the VCSEL. In addition to the designed lasing wavelength, these multiple spectral peaks further include other undesirable spectral peaks that appear on one or both sides of the designed lasing wavelength. These undesirable spectral peaks are generally called side modes. The appearance of side modes will lead to some potential problems, such as the inability of the LiDAR receiver to identify these side modes, resulting in efficiency drop and crosstalk. Other methods to reduce the divergence angle include using a high-contrast grating (HCG), using a slow-light optical amplifier, microlens integration, or utilizing different types of current confinement, such as ion implantation and buried tunnel junctions. However, these methods have their respective challenges, such as complex manufacturing, high cost, low power density, and difficulty in achieving uniform light-emission patterns.

## SUMMARY

An antireflective vertical-cavity surface-emitting laser and an antireflective vertical-cavity surface-emitting laser chip are provided according to embodiments of the present application, which can greatly reduce the divergence angle, increase the brightness and spectral brightness while maintaining a single-longitudinal-mode lasing, and avoid the issues of complex manufacturing, high cost, and low power density.

An antireflective vertical-cavity surface-emitting laser is provided according to embodiments of the present application, which includes: a lower Bragg reflector layer, an active region located on one side of the lower Bragg reflector layer, an upper Bragg reflector layer located on a side of the active region away from the lower Bragg reflector layer, and an antireflective light storage cavity located at at least one of a region between the lower Bragg reflector layer and the active region, or a region between the upper Bragg reflector layer and the active region and configured to increase the peak light field intensity to be higher than the peak light field intensity of the active region and to store light field energy. The active region includes at least five active layers and tunnel junctions between the active layers. A current confinement layer is provided in the active region or near the outer side of the active region. The antireflective vertical-cavity surface-emitting laser operates under conditions of an injection current density greater than 10 kA/cm$^2$, a slope efficiency greater than 4 W/A, and a far-field divergence angle less than or equal to 19°.

An antireflective vertical-cavity surface-emitting laser chip is provided according to embodiments of the present application, which includes at least one laser array. The laser array includes multiple antireflective vertical-cavity surface-emitting lasers as described in any embodiment of the present application. The laser array is a regularly arranged array, a randomly arranged array, or an array having multiple addressable sub-arrays.

## BRIEF DESCRIPTION OF DRAWINGS

FIG. 1 is a schematic structural diagram of an antireflective vertical-cavity surface-emitting laser provided in an embodiment of the present application;

FIG. 2 is a schematic structural diagram of a vertical-cavity surface-emitting laser with an extended cavity layer provided in the related art;

FIG. 3 is an array far-field pattern 500 mm away of a laser array consisting of the structure shown in FIG. 2;

FIG. 4 is a light field intensity distribution diagram and a refraction index distribution diagram of the structure shown in FIG. 2;

FIG. 5 shows the comparison between the temperature-dependent array lasing spectra of the laser array consisting of the structure shown in FIG. 2 and the reflection spectra of the FP longitudinal modes;

FIG. 6 is a schematic structural diagram of another antireflective vertical-cavity surface-emitting laser provided in an embodiment of the present application;

FIG. 7 is an array far-field pattern 50 mm away of a laser array consisting of the structure shown in FIG. 6;

FIG. 8 is a light field intensity distribution diagram and a refraction index distribution diagram of the structure shown in FIG. 6;

FIG. 9 shows the comparison between the temperature-dependent array lasing spectra of the laser array consisting of the structure shown in FIG. 6 and the reflection spectra of the FP longitudinal modes;

FIG. 10 is a comparison graph showing light intensity changes of a vertical-cavity surface-emitting laser in the related art and an antireflective vertical-cavity surface-emitting laser in an embodiment of the present application;

FIG. 11 to FIG. 15 are schematic diagrams of the construction principle of the electric field distribution in an antireflective vertical-cavity surface-emitting laser provided in an embodiment of the present application;

FIG. 16 shows the comparison between a laser array consisting of the structure shown in FIG. 6 provided in an embodiment of the present application and a laser array consisting of the structure shown in FIG. 2 in terms of the curve of the dependence of the averaged $M^2$ factor on the injection current, the array near-field image and the array far-field image;

FIG. 17 is a comparison graph of various photoelectric characteristics of the laser array consisting of the structure shown in FIG. 6 and various laser arrays in the related art;

FIG. 18 is a light field intensity distribution diagram and a refraction index distribution diagram of another antireflective vertical-cavity surface-emitting laser provided in an embodiment of the present application;

FIG. 19 shows the dependence of the divergence angle on the light confinement factor of an oxide layer provided in an embodiment of the present application;

FIG. 20 shows the dependence of the divergence angle on the effective cavity length provided in an embodiment of the present application;

FIG. 21 shows the dependences of the laser array brightness, spectral width, and spectral brightness respectively on the light confinement factor of the oxide layer provided in an embodiment of the present application;

FIG. 22 shows the dependence of the averaged $M^2$ factor of an AR-VCSEL array with different optical apertures on the current density provided in an embodiment of the present application;

FIG. 23 shows the lasing spectra of the $7\mu m$ optical aperture AR-VCSEL at different output powers provided in an embodiment of the present application;

FIG. 24 shows the comparison of near-field measured images and far-field measured images of a 7 $\mu m$ OA AR-VCSEL at different output powers provided in an embodiment of the present application;

FIG. 25 shows the comparison between AR-VCSELs provided in an embodiment of the present application and other types of semiconductor lasers applied in LiDARs in terms of brightness and power per unit effective area;

FIG. 26 shows the comparison between AR-VCSELs provided in an embodiment of the present application and other types of semiconductor lasers applied in LiDARs in terms of spectrum brightness and power per unit effective area;

FIG. 27 is a schematic structural diagram of a square laser array consisting of four square AR-VCSELs provided in an embodiment of the present application;

FIG. 28 is a schematic diagram of a far-field image of the structure shown in FIG. 27 measured at an injection current of 5.5 A;

FIG. 29 is a lasing spectrum diagram of the structure shown in FIG. 27 measured at an injection current of 5.5 A being injected at different temperatures;

FIG. 30 is a graph of various photoelectric characteristic curves of the structure shown in FIG. 27;

FIG. 31 is a schematic structural diagram of a hexagonal laser array consisting of 37 hexagonal AR-VCSELs provided in an embodiment of the present application;

FIG. 32 is a schematic diagram of a far-field image of the structure shown in FIG. 31 measured at an injection current of 10 A;

FIG. 33 is a lasing spectrum diagram of the structure shown in FIG. 31 measured at an injection current of 10 A being injected at different temperatures;

FIG. 34 is a graph of various photocurrent characteristic curves of the structure shown in FIG. 31;

FIG. 35 shows the comparison between the photoelectric characteristics of various AR-VCSEL arrays provided in the embodiments of the present application and various high-power laser arrays provided in the related art;

FIG. 36 is a schematic diagram of a free-space lens setting for single-emission lasing spectrum measurement provided in the embodiment of the present application; and

FIG. 37 is a schematic structural diagram of a driver circuit of a light source provided in an embodiment of the present application.

DETAILED DESCRIPTION

The technical solutions in the embodiments of the present application will be described hereinafter in conjunction with the drawings in the embodiments of the present application. Obviously, the described embodiments are only part of the embodiments of the present application, not all of the embodiments. Based on the embodiments in the present application, all other embodiments obtained by the person of ordinary skills in the art without making creative efforts should fall within the scope of protection of the present application.

It should be noted that the terms "first", "second", etc., in the specification and claims of the present application and the above drawings, are intended to distinguish similar objects, and are not necessarily used to describe a specific order or sequence. It should be understood that the terms used in this manner are interchangeable where appropriate so that the embodiments of the present application described herein can be implemented in an order other than that illustrated or described herein. Furthermore, the terms "including" and "having" and any variations thereof are intended to cover non-exclusive inclusions, for example, a process, method, system, product, or apparatus including a series of steps or units is not necessarily limited to those steps or units listed, but may include other steps or units not listed or inherent to these processes, methods, products, or apparatus.

As mentioned in the background technology, the compactness, fast response, and high energy conversion efficiency have made VCSEL arrays a major light source for high-speed data communication and sensing. LiDAR systems equipped with VCSEL array solid-state light sources are commercialized in autonomous-driving vehicles. There are many performance metrics for High-resolution LiDAR light sources, such as power, power density, divergence angle, beam quality, beam parameter product, spectral width, brightness, spectral brightness, wavelength, temperature stability, pulse width, energy conversion efficiency, on-off speed, module size, and power per active region. The brightness, defined in formula (1) as the power density per unit solid angle $\Omega\Delta$ (in Steradian, sr), consolidates the first five metrics. In equation (1), *Brightness* is the brightness, *Power destiny* is the power density, $\Omega\Delta$ is the solid angle, and *A* is the light-emission area.

$$Brightness = \frac{Power\ density}{\Delta\Omega} = \frac{Power}{A\Delta\Omega}\ (1);$$

The spectral brightness is defined as

$$Spectral\ Brightness = \frac{Brightness}{\Delta\lambda} = \frac{Power}{A\Delta\Omega\Delta\lambda}\ (2);$$

In formula (2), *Spectral Brightness* as the spectral brightness with $\Delta\lambda$ as the spectral width, consolidates the first six metrics.

Brightness is particularly important for LiDAR systems that utilize collimated laser beams for scanning. The higher the brightness is, the farther the scanning LiDAR system can perceive and the higher the angular resolution. On the receiving side, narrow bandpass filters are typically applied in front of the detector for a high signal-to-noise ratio, enabling a longer perceiving distance. The system signal-to-noise ratio is inversely proportional to the filter bandwidth. The smaller the filter bandwidth is, the higher the system signal-to-noise ratio is. Conventionally, the bandwidth of the filter covers the entire range of the laser source wavelength shift over -40°C to 125°C required by the Automotive Electronics Council standard. However, if the temperature coefficient of the wavelength drift of the filter can closely match the laser source, the filter bandwidth can be significantly narrower. Furthermore, if the filter wavelength-angle shift can also be minimized to a negligible level, the filter bandwidth can even approach the lasing spectral width itself. In this case, spectral brightness becomes even more important to evaluate a laser source's ultimate capability to enable a high signal-to-noise ratio.

For an array-type laser source, the light-emission area A is defined as the area of the smallest circle or rectangle that encloses all emitters. The solid angle can be expressed as $\Delta\Omega = \iint sin\theta d\theta d\varphi \approx \pi\theta^2$, where $\theta$ is the divergence half-angle, , with the approximation that $sin\theta \approx \theta$ when $\theta$ is small. The denominator $A\Delta\Omega$ (optical etendue) in equation (1) is conserved as the light beam travels through any ideal collimating lens systems. It can only increase when any optics are nonideal during in propagation. Similarly, power can only be maintained or deteriorated by any optical losses in the process of propagation. As a result, brightness and spectral brightness can only deteriorate, or at best, be maintained in a lossless ideal lens system. Therefore, in addition to perfecting the optics and increasing the laser emission power, reducing the etendue of the original laser beam from the die is critical to achieving high brightness and high spectral brightness for distant objects.

There has been a long-standing debate between edge-emitting lasers (EELs) and VCSELs in terms of the choice of light source for LiDARs. EELs were introduced to LiDAR applications earlier than VCSELs because single-bar EELs typically produce much higher power than single-emitter VCSELs. However, recently, the preference has begun to shift to VCSELs. Compared with high-power Fabry-Pérot (FP) EELs, VCSELs have a narrower spectral width (<2 nm) and better wavelength stability with temperature (0.06~0.07 nm/°C). Over a wide temperature range of -40°C~125°C, the VCSEL wavelength drifts by only 12 nm, allowing a narrow bandpass filter even without a wavelength-drift-matching. A LiDAR filter specially designed to match the temperature coefficient of wavelength drift 0.06 nm/°C~0.07 nm/°C of VCSELs is possible. However, to make the temperature coefficient of wavelength drift of the filter as large as FP EELs' 0.2 nm/°C~0.3 nm/°C is pragmatically difficult, if not impossible. In another aspect, EELs with improved wavelength stability (such as distributed feedback (DFB) lasers and distributed Bragg reflector (DBR) lasers) require carefully designed Bragg gratings and additional manufacturing processes, such as electron beam lithography. Furthermore, VCSELs can produce superior beams with circular symmetry, while the EEL beam profile is asymmetric. Finally, the inherent two-dimensional (2D) array manufacturability endows VCSELs with unparalleled advantages over EELs in two-dimensional point cloud generation and chip-scale optical integration without complex optics or complicated packaging. Due to these advantages, many LiDAR manufacturers are adopting VCSEL arrays as their light sources. However, compared with EELs, conventional VCSEL array designs still need higher power density, smaller divergence angles, and higher spectral brightness to prevail the competition for LiDAR light sources.

There have been several ways to improve the VCSEL power density to the order of 1000 W/mm$^2$, which is comparable to the power density of high-power EEL arrays. First, medium and long-range LiDARs use short nanosecond pulses and operate at low duty cycles, resulting in a relatively low time-averaged power that avoids overheating of laser chips, which enables a laser with increased peak power. Furthermore, a series-connected or a multi-junction structure can be used for the VCSEL. By connecting several P-N junctions in series with tunnel junctions vertically without increasing the emission area, a slope efficiency (SE, in units of W/A) proportional to the number of P-N junctions can be produced, thereby significantly improving the power density. From an energy-saving perspective, for a fixed required optical power output, the series-connected structure effectively reduces the input current by elevating the input voltage (which is not an issue for automobiles, although more limited for consumer electronics). The lower current generates less waste heat from the parasitic series resistance in the driver circuit, which improves the energy conversion efficiency of the system. Leading companies in the VCSEL industry are now mass-producing 5-junction to 7-junction VCSELs, and the VCSELs with larger numbers of junctions are under development. In addition to multi-junction, the VCSEL power density can be further boosted by increasing the effective emission area over the entire VCSEL array region (filling factor) and stretching the operating current as long as the device lifetime allows, so as to further improve the energy conversion efficiency.

Although multi-junction structures can also be adapted for EELs, their power density is limited by the necessary separation of optical modes from each junction, because the tunnel junctions must be placed at light field minima between optical modes to avoid unacceptable loss caused by light field energy absorption. Furthermore, there are potential reliability issues of catastrophic optical damage (COD) in a case of, for example, a too small spacing distance of the P-N junctions. Typically, the junctions in an EEL are spaced by as much as a few micrometers, and appear as separate emitters in near-field imaging. Therefore, applying multiple junctions in an EEL will not increase the power density of the EEL.

Since the power density of VCSELs has become sufficient for LiDARs, there is an urgent need to reduce its beam divergence angle to obtain higher brightness. Because a lower beam divergence angle is usually accompanied by fewer high-order modes and a narrower spectral width, and the impact of the lower beam divergence angle on the spectral brightness is doubled. The typical full divergence angle in D86 is defined as the angle at which the D86 beam width in the far field proportionally increases with the distance from the light source, where the D86 beam width in the far field is defined as the diameter of the circle centered at the centroid of the beam far field profile and containing 86% of the light field energy. The typical full divergence angle in D86 of oxide layer (current confinement layer) -based VCSELs is generally 20°~30°, which is quite large for most medium- and long-range (>100m) scanning LiDARs. Multi-junction VCSELs that have multiple oxide layers for current confinement may suffer from even larger divergence angles than single-junction VCSELs due to stronger transverse optical confinement.

Reducing the number of oxide layers in multi-junction VCSELs may cause power conversion efficiency (PCE) loss; otherwise, additional current confinement, such as ion implantation, is required. The conventional method to reduce the VCSEL beam divergence angle while maintaining the efficiency is to extend the cavity length with an extended cavity layer, thereby reducing the contrast of the effective refraction index ($\Delta$n) between the inside and outside of the VCSEL's optical aperture. Such reduced refraction index contrast suppresses the generation of high-order transverse modes. Therefore, the extended cavity layer effectively acts as a higher-order mode suppressor or a "low pass" mode filter. After the higher-order mode beams that exhibit lower beam quality (large $M^2$ factor and large divergence angle) are filtered out, the lower-order mode beams with a small divergence angle will dominate the laser modal operation. Other methods to reduce the divergence angle include using a high-contrast grating (HCG), using a slow-light optical amplifier, microlens integration, or utilizing different types of current confinement, for example, ion implantation and buried tunnel junctions. However, these methods have their respective challenges, such as complex manufacturing, high cost, low power density, and difficulty in achieving uniform light-emission patterns.

However, the method of lengthening the cavity length will cause new problems. After the cavity length is lengthened, the longitudinal mode spacing of the laser decreases, and the emission spectrum of the VCSEL may show multiple longitudinal modes, that is, show multiple spectral peaks. In addition to the lasing wavelength we designed, other undesirable spectral peaks appear on one or both sides of the lasing wavelength we designed. These undesirable spectral peaks are usually called side modes. The appearance of side modes may lead to some potential risks, for example, increased temperature coefficient of wavelength drift and reduced temperature stability of the light source; and further for example, the incapability of the receiving side of the LiDAR and the three-dimensional sensor to recognize these side modes, resulting in efficiency drop and crosstalk, etc.

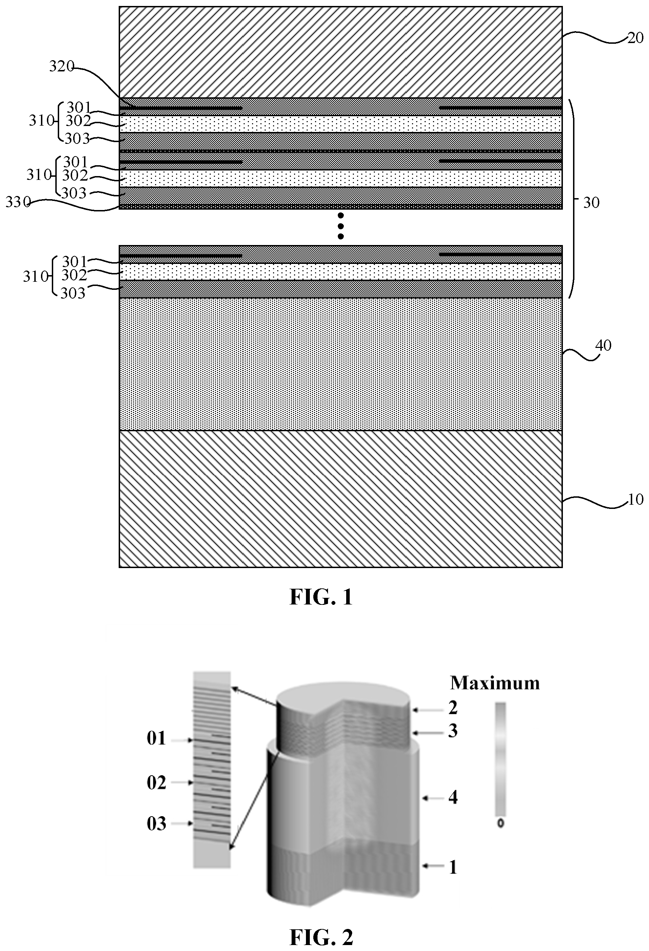

An antireflective vertical-cavity surface-emitting laser (AR-VCSEL) is provided according to an embodiment of the present application. FIG. 1 is a schematic structural diagram of an antireflective vertical-cavity surface-emitting laser provided in an embodiment of the present application. Referring to FIG. 1, the antireflective vertical-cavity surface-emitting laser includes: a lower Bragg reflector layer 10, an active region 30 located on a side of the lower Bragg reflector layer 10, an upper Bragg reflector layer 20 located on a side of the active region 30 away from the lower Bragg reflector layer 10, and an antireflective light storage cavity 40 located at at least one of a region between the lower Bragg reflector layer 10 and the active region 30, or a region between the upper Bragg reflector layer 20 and the active region 30 and configured to increase the peak light field intensity thereof to be higher than the peak light field intensity of the active region 30 and to store light field energy. The active region 30 includes at least five active layers 310 and tunnel junctions 330 between the active layers 310. A current confinement layer 320 is provided in the active region 30 or near the outer side of the active region 30. The antireflective vertical-cavity surface-emitting laser operates under conditions of an injection current density greater than 10 kA/cm$^2$, a slope efficiency greater than 4 W/A, and a far-field divergence angle (full angle in D86) less than or equal to 19°.

The antireflective vertical-cavity surface-emitting laser provided in the embodiments of the present application operates under conditions that the injection current density is greater than 10 kA/cm$^2$, the slope efficiency is greater than 4 W/A, and the full angle in D86 of the far-field divergence angle is less than or equal to 19°. The antireflective light storage cavity is set at at least one of a region between the multi-junction active region and the lower Bragg reflector layer, or a region between the multi-junction active region and the upper Bragg reflector layer; and the antireflective light storage cavity may have a peak light field intensity increased to be higher than the peak light field intensity in the multi-junction active region, and store the light field energy, so that the light field intensity in the antireflective light storage cavity is higher than the light field intensity in the multi-junction active region, thereby reducing the difference in the effective refraction index between the inside and outside of the VCSEL light-emission aperture, suppressing the generation of high-order modes, and reducing the divergence angle. Moreover, increasing the light field intensity inside the antireflective light storage cavity, compared with the method of increasing the cavity length in the related art, can reduce the amplitude of the increase in the cavity length, and further mitigate the issue that multiple longitudinal modes appear in the emission spectrum of the VCSEL, thereby achieving a significantly reduced divergence angle while maintaining a single-longitudinal-mode lasing. In addition, there is no need to use a high-contrast grating (HCG), a slow-light optical amplifier, perform microlens integration, or utilize different types of current confinement, avoiding issues such as complex manufacturing, high cost, and low power density. The active region includes at least five active layers, and the laser operates under operation conditions of an injection current density greater than 10 kA/cm$^2$ and a slope efficiency greater than 4 W/A, which can increase brightness and spectral brightness.

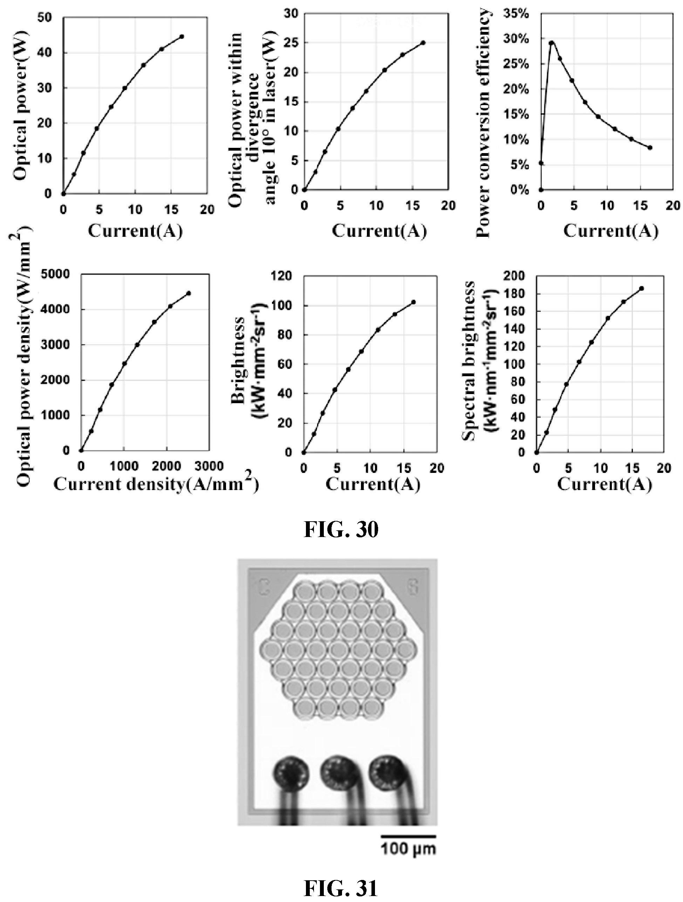

For fair comparison, in an embodiment of the present application, the far-field divergence angle, the light field intensity distribution in a laser and the temperature-dependent spectra of a VCSEL array in the related art are tested, and the far-field divergence angle, the light field intensity distribution in a laser and the temperature-dependent spectra of an AR-VCSEL array provided in an embodiment of the present application are tested. Each array consists of 37 emitters with emitter-to-emitter distance of 40 $\mu$m, each with an optical aperture (aperture of the light-emission aperture) of 22 $\mu$m, forming a hexagonal light-emission region with a size of approximately 250 $\mu$m (reference can be made to FIG. 31 for the array arrangement pattern).

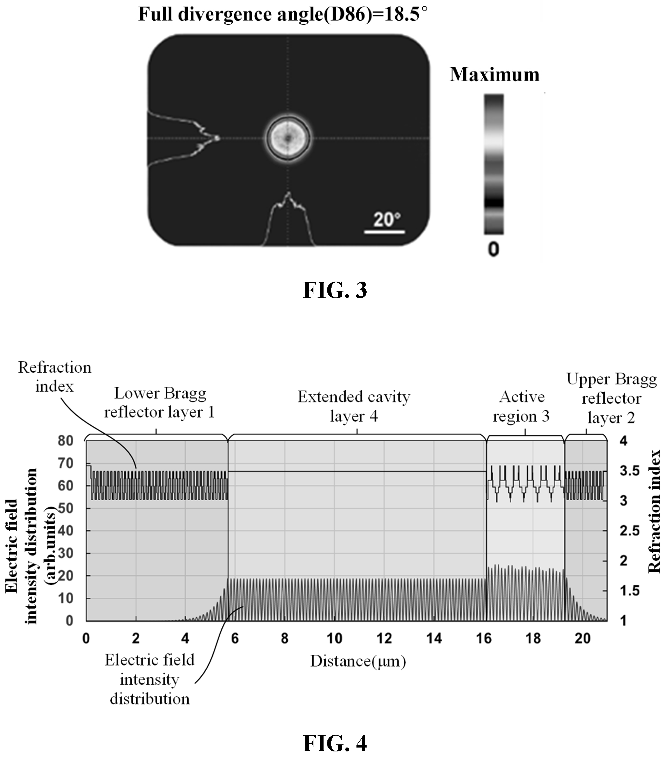

FIG. 2 is a schematic structural diagram of a vertical-cavity surface-emitting laser with an extended cavity layer provided in the related art. Each VCSEL in the VCSEL array is an extended cavity VCSEL as shown in FIG. 2. Referring to FIG. 2, the extended cavity VCSEL has an upper Bragg reflector layer 2, an active region 3 including 6-junction active layers, an extended cavity layer 4, and a lower Bragg reflector layer 1. One or more active layers include a quantum well 01, and a tunnel junction 02 is arranged between adjacent active layers. In each active layer, a current confinement layer 03 is provided. FIG. 3 is an array far-field pattern 50 mm away of a laser array consisting of the structure shown in FIG. 2. Referring to FIG. 3, the far-field divergence angle of the VCSEL array in the related art is measured to be 18.5°. FIG. 4 is a light field intensity distribution diagram and a refraction index distribution diagram of the structure shown in FIG. 2. Referring to FIG. 4 which shows the refraction index distribution and electric field intensity distribution of the output level after being normalized along the vertical axis (the epitaxial direction is from left to right), the electric field intensity distributed in the entire active region 3 and the electric field intensity of the extended cavity layer 4 are relatively uniform, and the difference between the peak value of the electric field intensity distributed in the entire active region 3 and the peak value of the electric field intensity distributed in the extended cavity layer 4 is small. The lasing wavelength is designed at 905 mm. The extended cavity layer 4 acts as a high-order mode filter because it suppresses the generation of high-order transverse modes so that the divergence angle is reduced from the range of 20°~30° to 18.5°. The reasons are analyzed as follows.

In the VCSEL, a current confinement layer 03 is provided in the active region 3 or near the outside of the active region 3. The current confinement layer 03 includes an oxide layer, and the oxide layer is epitaxially grown high-Al-content AlGaAs. An oxidized region on the outer side of the oxide layer forms an insulating aluminum oxide film layer; and an un-oxidized region of the oxide layer forms an effective current-injected light-emission region, that is, the light-emission aperture of the laser. The refraction index of the AlGaAs in the middle of the current confinement layer 03 is different from the refraction index of the aluminum oxide on the outside, which results in a difference in the effective refraction index between the inside and outside of the VCSEL light-emission aperture. The effective refraction index is determined based on the following formula:

$$n_{eff} = \frac{\int n(z)E^2(z)dz}{\int E^2(z)dz} \quad (3);$$

Specifically, $n_{eff}$ is the effective refraction index, $n(z)$ is the refraction index in the z-axis direction, and $E^2(z)$ is the light field intensity in the z-axis direction (i.e. the light-emission direction). The integration range is over the light field in the laser.

The difference between effective refraction indices inside and outside the VCSEL light-emission aperture is determined based on the following formula:

$$\Delta n_{eff} = n_{1_{eff}} - n_{2_{eff}} = \Gamma_{ox} \times (n_1 - n_2) \quad (4);$$

Specifically, $\Delta n_{eff}$ is the difference between effective refraction indices inside and outside the light-emission aperture, $n_{1\_eff}$ is the effective refraction index of the region where the light-emission aperture is located, $n_{2\_eff}$ is the effective refraction index outside the light-emission aperture, $n_1$ is the refraction index of the high-aluminum-content material (such as $Al_{0.98}Ga_{0.02}As$), and $n_2$ is the refraction index of aluminum oxide. $\Gamma_{ox}$ is the light confinement factor of the oxide layer, which is determined based on the following formula:

$$\Gamma_{ox} = \frac{\int_0^l n_2(z)E^2(z)dz}{\int_0^p n(z)E^2(z)dz} \quad (5);$$

Specifically, $l$ is the thickness of the current confinement layer 320 in the z-axis direction, and $p$ is the thickness of the entire light field in the z-axis direction.

According to the step-index waveguide theory, linearly polarized (LP) transverse modes are present in radially symmetric refraction index profile with weak refractive index guiding, which is applicable to the case of oxide-confined VCSELs. The beam quality of each LP mode depends on the mode order. The lowest order mode, that is, the so-called fundamental mode, has the highest beam quality, or the lowest $M^2$ factor ($M^2=1$), and therefore the smallest divergence angle once the mode is coupled from the waveguide into free space. The higher the mode order, the higher the $M^2$ factor ($M^2>1$), and the larger the divergence angle. The number and orders of allowed LP modes depend largely on the effective refraction index contrast between the core and cladding regions of the refraction index profile, which correspond to the inside and outside of the light-emission aperture of a VCSEL. By minimizing $\Gamma_{ox}$ and $\Delta n_{eff}$, the number of allowed LP modes is reduced, resulting in a smaller divergence angle. Minimizing $\Gamma_{ox}$ and $\Delta n_{eff}$ can be facilitated by increasing the cavity length (by providing the extended cavity layer 4), placing oxide layers at the node positions of the standing wave electron field, and reducing the number and thicknesses of oxide layers.

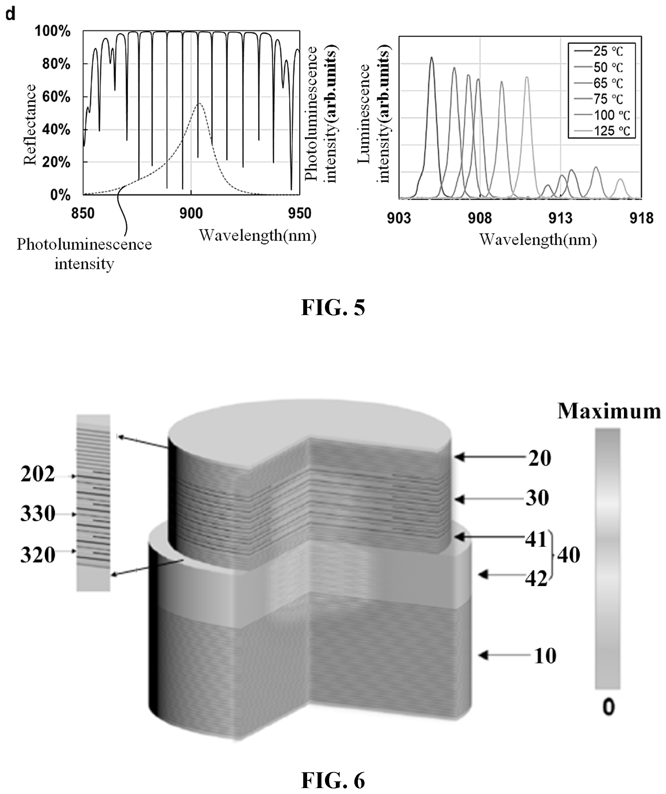

However, a large cavity length also poses new risks. The primary issue is that the longitudinal mode spacing or the free spectral range (FSR) decreases as the effective cavity length $L_{eff}$ increases, hindering single-longitudinal-mode operation. The emission spectrum of the VCSEL shows multiple lasing wavelengths in addition to the desired lasing mode, and the multiple lasing wavelengths appear on one or both sides of the designed lasing wavelength. FIG. 5 shows the comparison between the temperature-dependent array lasing spectra of the laser array consisting of the structure shown in FIG. 2 and the reflection spectra of the FP longitudinal modes. The left figure in FIG. 5 shows the reflection spectrum (solid black line) of the entire VCSEL structure in FIG. 2, showing the FP longitudinal modes, and the measured photoluminescence spectrum (dashed gray line) from the active region shifted to be aligned with the central FP dip for illustration purposes. The FSR is as narrow as 7.5 nm. The full width at half maxima (FWHM) of the photoluminescence (PL) spectrum measured from the active region 3 is about 20 nm, which is larger than the mode spacing. If two longitudinal modes are covered by the emission spectrum of the active region 3 and are within the stopbands of the top DBR (upper Bragg reflector layer) and the bottom DBR (lower Bragg reflector layer), the two longitudinal modes lase simultaneously. Referring to the right figure in FIG. 5, the temperature-dependent array lasing spectra (from 25°C to 125°C) were measured, showing two longitudinal lasing modes.

As shown in FIG. 3, although with a small $\Gamma_{ox}$ of 0.131%, the divergence angle of such a laser array is 18.5° (D86 full angle), but for most applications, multi-longitudinal-mode lasing (as shown in the right figure in FIG. 5) is unacceptable because it may cause potential issues such as temperature instability and efficiency loss from receiving filters. Although such multi-wavelength lasing can be somewhat rectified by reducing the stopband width of the top DBR (upper Bragg reflector layer 2) and reducing the refraction index contrast, the divergence angle is eventually limited by epitaxial thickness-induced stress, wafer bowing, and subsequent manufacturing difficulties. For a single-longitudinal-mode oxide VCSEL with more than five junction active layers, it can hardly achieve a D86 full angle of less than 16°. A better low-divergence design is needed to utilize the cavity length.

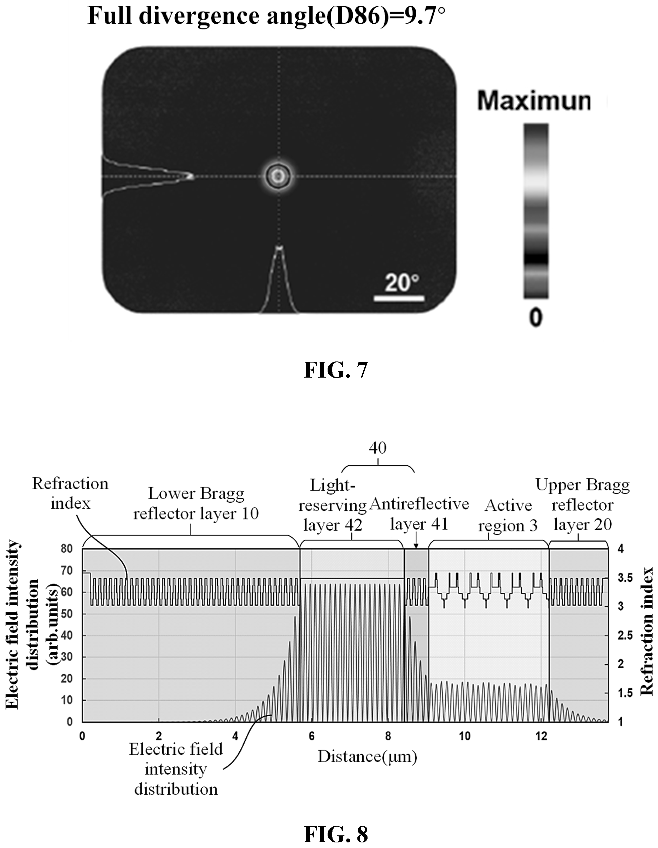

FIG. 6 is a schematic structural diagram of another antireflective vertical-cavity surface-emitting laser provided in an embodiment of the present application. Referring to FIG. 6, each AR-VCSEL in the AR-VCSEL array is an antireflective vertical-cavity surface-emitting laser as shown in FIG. 6. Referring to FIG. 6, the antireflective vertical-cavity surface-emitting laser has an upper Bragg reflector layer 20, an active region 30 including 6-junction active layers 310, an antireflective light storage cavity 40 and a lower Bragg reflector layer 10, and each adjacent active layers have a tunnel junction 330 arranged therebetween. Each active layer 310 has a current confinement layer 320 arranged therein. The antireflective light storage cavity 40 includes: an antireflective layer 41 and a light storage layer 42. The antireflective layer 41 is located between the light storage layer 42 and the active region 30. The antireflective layer 41 is configured to increase the peak light field intensity of the light storage layer 42 to be higher than the peak light field intensity of the active region 30. The light storage layer 42 is configured to store light field energy. FIG. 7 is an array far-field pattern 50mm away of a laser array consisting of the structure shown in FIG. 6. Referring to FIG. 7, the far-field divergence angle of the AR-VCSEL array is measured to be 9.7°.

In the direction from the active region 30 to the antireflective light storage cavity 40, the antireflective layer 41 includes a first antireflective interface located at the interface from low refraction index to high refraction index between the light storage layer 42 and the active region 30, and/or a second antireflective interface located at the interface from high refraction index to low refraction index between the light storage layer 42 and the active region 30. The optical path distance between the first antireflective interface and the nearest standing wave light field antinode position is less than one-tenth of the lasing wavelength; the optical path distance between the second antireflective interface and the nearest standing wave light field node position is less than one-tenth of the lasing wavelength. FIG. 8 is a light field intensity distribution diagram and a refraction index distribution diagram of the structure shown in FIG. 6. Referring to FIG. 8, the antireflective layer 41 is formed by multiple quarter-wavelength-thick n-doped AlGaAs film layers (which may be referred to as antireflective sub-layers) alternately arranged according to high and low aluminum contents, and the light storage layer 42 can be a 2 $\mu$m-thick film layer made of AlGaAs. The thickness of the light storage layer is an odd multiple of half the lasing wavelength. FIG. 8 exemplarily shows that the antireflective layer 41 includes first antireflective interfaces and second antireflective interfaces, and the first antireflective interfaces and the second antireflective interfaces are arranged alternately. Multiple antireflective interfaces are arranged between the active region 30 and the light storage layer 42 so that the electric field intensity from the active region 30 to the light storage layer 42 gradually increases.

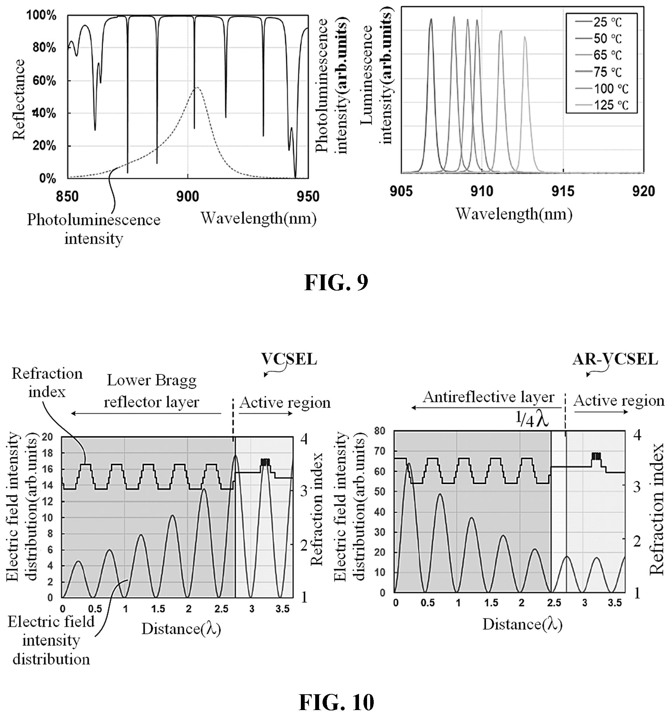

In this embodiment of the present application, on one side of the active region 30, instead of a simple extension of the cavity, an antireflective layer 41 is added, so that light can be extracted from the active region 30 and stored in the light storage layer 42, which, like an optical dam, holds photons to raise light field intensity. In this way, the total electric field energy in the light storage layer 42 is several times that of an ordinary extended cavity layer with the same spatial volume. Optionally, the peak electric field intensities of different active layers are the same or different; the maximum peak electric field intensity in the active region is less than the maximum peak electric field intensity in the antireflective light storage cavity. As shown in FIG. 8, when the two output levels are normalized to unity, the peak electric field intensity inside the light storage layer 42 is about three times the peak electric field intensity in the active region 30, and about four to five times the peak electric field intensity in the extended cavity layer 4 in FIG. 4. FIG. 9 shows the comparison between the temperature-dependent array lasing spectra of the laser array consisting of the structure shown in FIG. 6 and the reflection spectra of the FP longitudinal modes. Referring to FIG. 9, the strong electric field intensity inside the light storage layer lessens the dependence of the divergence angle on the length of the extended cavity layer. Therefore, only a moderate length of the light storage layer 42 is further required while maintaining a large FSR of about 16 nm (left figure in FIG. 9) to reach an even smaller divergence angle, with a $\Gamma_{ox}$ reduced by 0.027%, while maintaining a single longitudinal mode (right figure in FIG. 9).

FIG. 10 is a comparison graph showing light intensity changes of a vertical-cavity surface-emitting laser in the related art and an antireflective vertical-cavity surface-emitting laser in an embodiment of the present application. Referring to FIG. 10, it shows the comparison between the close-range electric field intensity at the interface of the active region/lower Bragg reflector layer in the conventional VCSEL structure (left figure in FIG. 10) and the close-range electric field intensity at the interface of the active region/antireflective layer in the AR-VCSEL structure (right figure in FIG. 10). In the antireflective layer, there is a quarter-wavelength spacer layer on the side of the active region 30 so that the electric field antinode positions shift from their initial refraction index-decreasing interfaces in the left figure in FIG. 10 to the refraction index-increasing interfaces in the right figure in FIG. 10 in the direction from the active region 30 to the lower Bragg reflector layer 10. That is, the antireflective layer 41 consists of several pairs of film layers similar to the lower Bragg reflector layer 10 but designed with a special $\pi/2$ (quarter-wavelength) phase shift. The photons generated from the active region 30 and propagating toward the lower Bragg reflector layer 10 constructively interfere at each antireflective sublayer and reach increasingly higher intensities until stabilization at the light storage layer 42. It should be noted that in the AR-VCSEL structure in FIG. 10, the antireflective layer 41 is located between the lower Bragg reflector layer 10 and the active region 30.

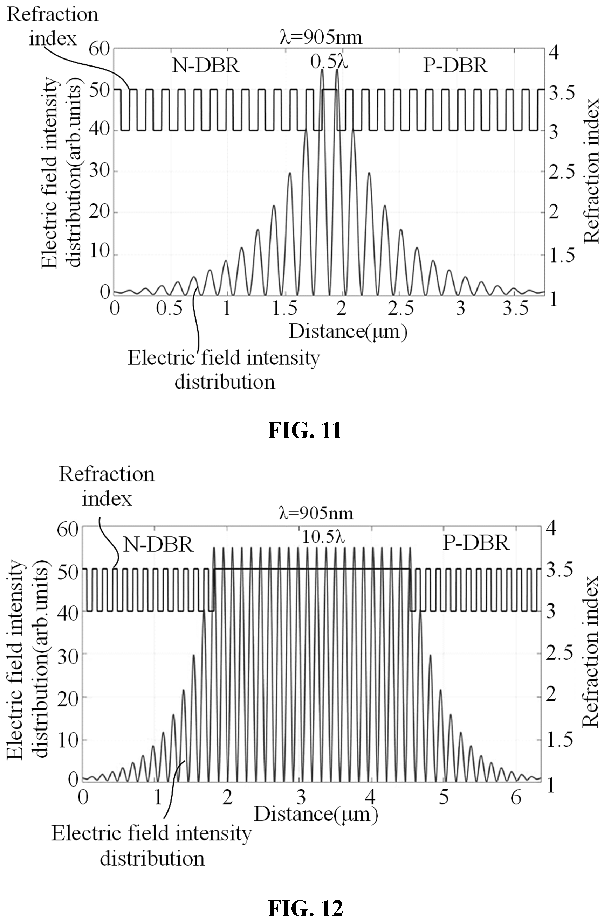

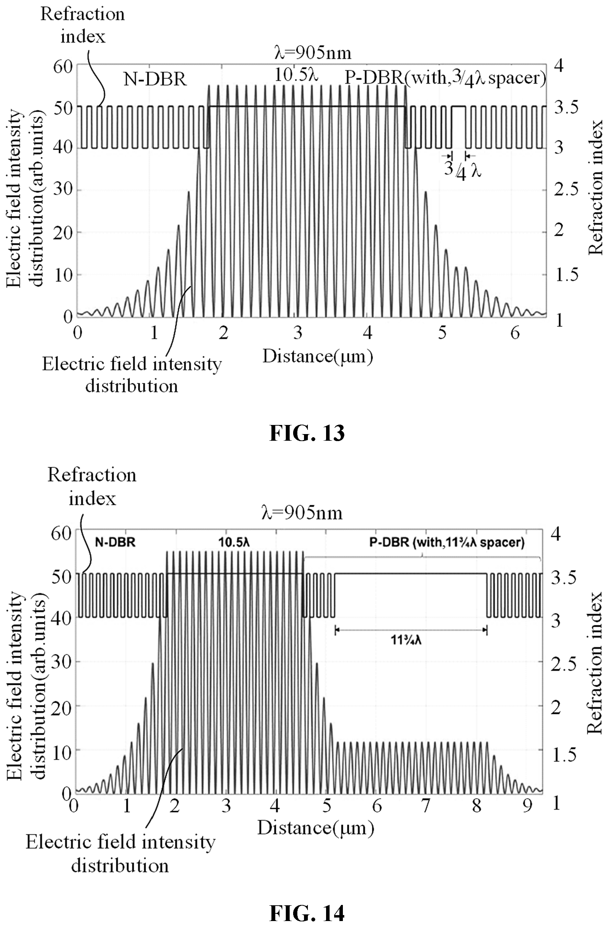

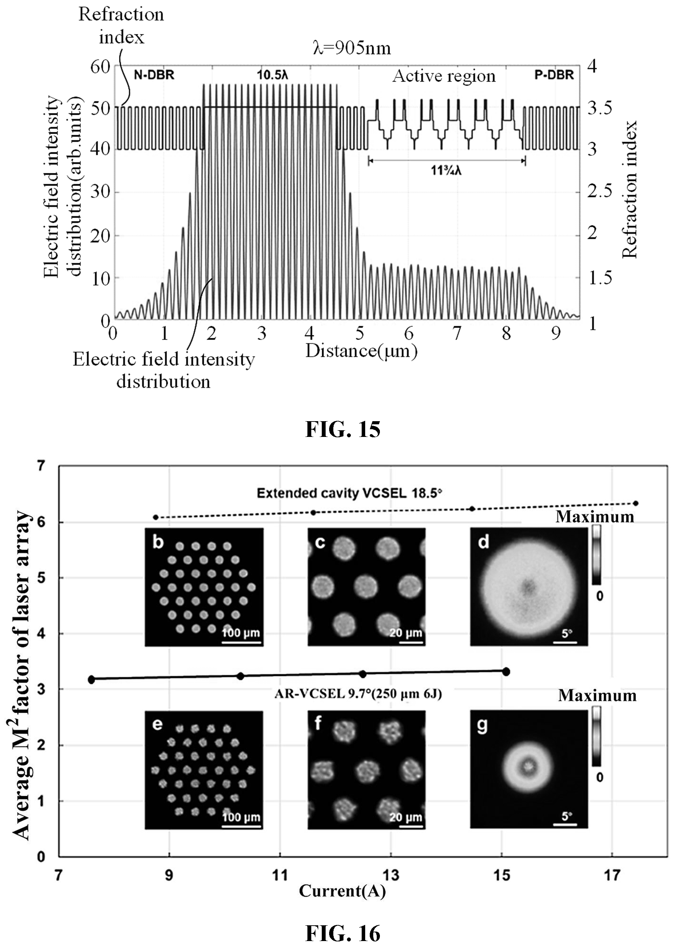

FIG. 11 to FIG. 15 are schematic diagrams of the construction principle of the electric field distribution in an antireflective vertical-cavity surface-emitting laser provided in an embodiment of the present application. Referring to FIG. 11 to FIG. 15, how the electric field is constructed in the AR-VCSEL is explained. Referring to FIG. 11, a simple $0.5\lambda$ cavity VCSEL with N-DBR and P-DBR is first represented by a standing wave electric field intensity and refraction index distribution diagram. The N-DBR includes multiple reflectors, each with an optical thickness of one-quarter of the lasing wavelength, arranged alternately according to high and low refraction indices. The P-DBR includes multiple reflectors, each with an optical thickness of one-quarter of the lasing wavelength, arranged alternately according to high and low refraction indices. Compared with the electric field at two ends of the structure (where the electric field intensity is set to 1), the relative electric field intensity inside the $0.5\lambda$ cavity is very high (>50). Referring to FIG. 12, the cavity length is then extended from $0.5\lambda$ to $10.5\lambda$; it should be noted that any $(1/2+m/2)\lambda$ (m is a positive integer) cavity length does not disturb the electric field distribution in the DBR. Referring to FIG. 13, the thickness of one of the reflectors in the P-DBR is extended from $\frac{1}{4}\lambda$ to $\frac{3}{4}\lambda$; it should be noted that the thickness of the DBR can be $(1/4+m/2)\lambda$, where m is a positive integer, without affecting the electric field intensity anywhere else; and adding an additional spacer of $(m/2)\lambda$ within the DBR does not create another resonant cavity. Referring to FIG. 14, the thickness of the $\frac{3}{4}\lambda$ layer in the P-DBR is extended to $11\frac{3}{4}\lambda$, and the electric field intensity distribution elsewhere remains unchanged. Referring to FIG. 15, the $11\frac{3}{4}\lambda$ layer is finally

replaced with an active region which has an optical thickness of 11¾λ. By placing multiple quantum wells at the electric field standing wave antinode positions and also placing the tunnel junctions and oxide layers at the node positions, the electric field distribution can be maintained to the greatest extent. No additional cavities are added in this process. The initial 10.5λ cavity is just the light storage layer.

The unique design provided in the embodiment of the present application transforms the long cavity extension into a shorter extension but with a much stronger electric field. Such an antireflective light storage cavity 40 is more efficient in storing photons in each unit of cavity length, thereby more effectively lowering $\Gamma_{ox}$. The photons stored in the light storage layer feel almost no lateral confinement, and they are essentially "free" laterally, which significantly reduces the overall divergence angle. In some embodiments of the present application, the light confinement factor $\Gamma_{ox}$ of the oxide layer is less than 0.16%.

FIG. 16 shows the comparison between a laser array consisting of the structure shown in FIG. 6 provided in an embodiment of the present application and a laser array consisting of the structure shown in FIG. 2 in terms of the curve of the dependence of the averaged $M^2$ factor on the injection current, the array near-field image and the array far-field image. Reference is made to FIG. 16, which shows the comparison between a curve of the averaged $M^2$ factor of the lasers in the AR-VCSEL array changing with the injection current and a curve of the averaged $M^2$ factor of the lasers in the extended-cavity VCSEL array changing with the injection current (image e and image b in FIG. 16, respectively), as well as a comparison between the near-field images of the AR-VCSEL array and the extended-cavity VCSEL array (image f and image c in FIG. 16 respectively) and a comparison between the far-field images of the AR-VCSEL array and the extended-cavity VCSEL array (image g and image d in FIG. 16, respectively). The averaged $M^2$ factor is proportional to the far-field divergence angle (FF), $M^2 = \pi r\theta/\lambda = \pi r\Theta/(2\lambda)$, where $\Theta$ is the full angle in D86 and $\theta$ is the divergence half-angle, ($\Theta = 2\theta$). The averaged $M^2$ factor is relatively stable at different current injection levels for both the AR-VCSEL array and the extended cavity VCSEL array. In the near-field image of the AR-VCSEL array (such as image f in FIG. 16), the sparser speckles indicate fewer number of transverse modes, which is consistent with its reduced $\Gamma_{ox}$. The near-field image and far-field image were measured at a current of 10 A. The averaged $M^2$ factor of all individual emitters in an array is calculated assuming that the beam waist radius (r) is equal to the optical aperture radius.

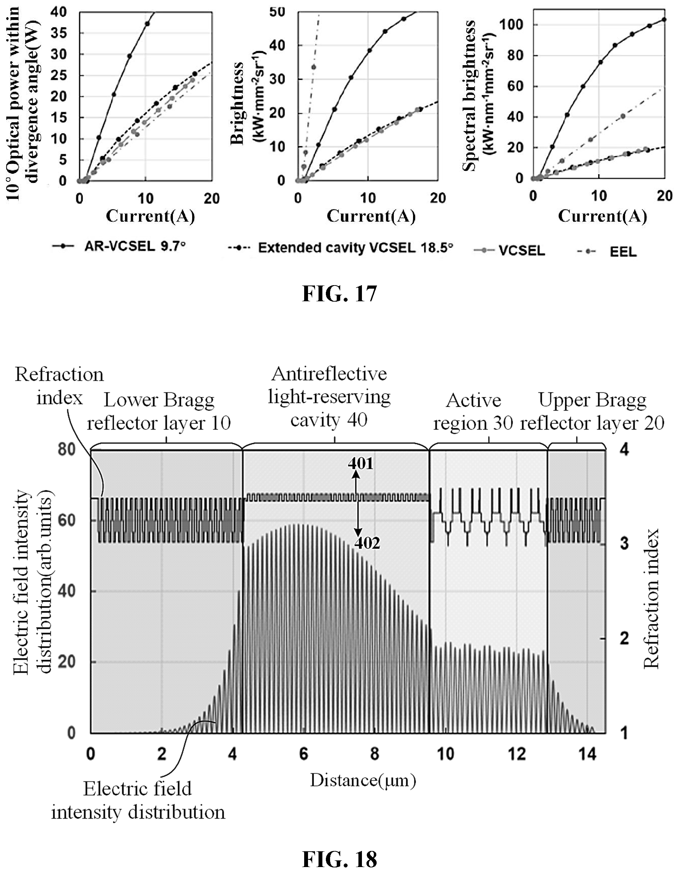

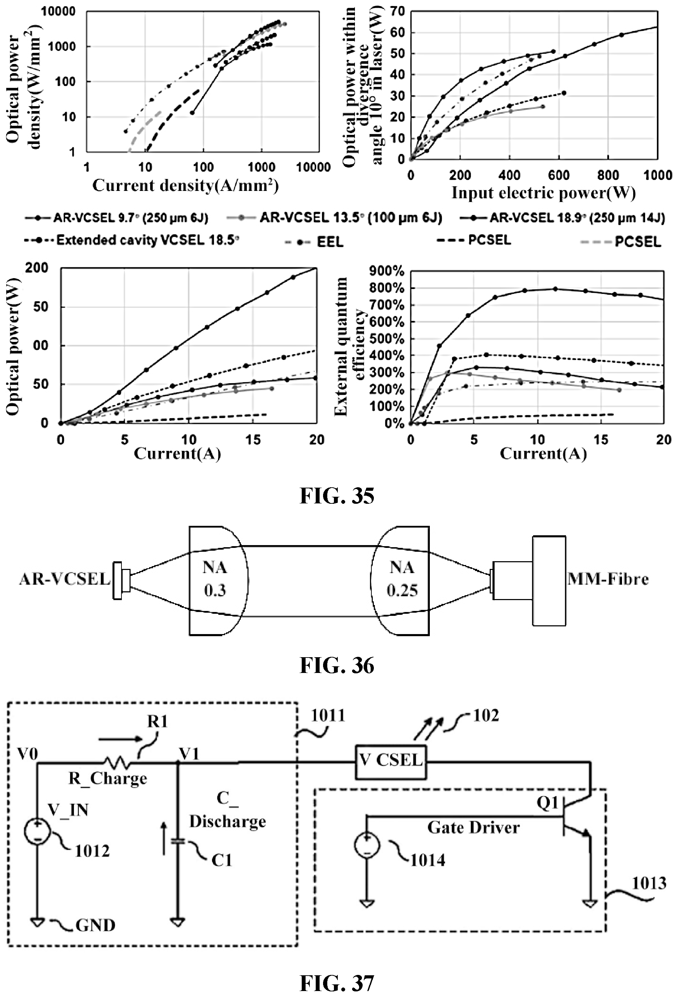

FIG. 17 is shows the comparison of various photoelectric characteristics of the laser array consisting of the structure shown in FIG. 6 and various laser arrays in the related art. Referring to FIG. 17, the performances of the AR-VCSEL, the extended cavity VCSEL, the state-of-the-art commercial multi-junction VCSEL, and the state-of-the-art commercial multi-junction EEL for LiDAR in terms of brightness, spectral brightness and light output power within a 10° field of view are compared. In comparison, the AR-VCSEL array provided in the embodiment of the present application has dramatically improved performance in all three metrics. With identical array size and layout, the AR-VCSEL has more than double the power of the extended cavity VCSEL contained within a 10° field of view (FOV). The brightness increases by threefold from 12.5 kW*mm$^{-2}$sr$^{-l}$ to 38.5 kW*mm$^{-2}$sr$^{-l}$; and the spectral brightness increases by more than sixfold from 12.2 kW*nm$^{-1}$mm$^{-2}$sr$^{-l}$ to 75.6 kW* nm$^{-1}$mm$^{-2}$sr$^{-1}$, though there is a slight reduction in the external quantum efficiency (see FIG. 35) due to the increased high-order mode loss. Compared with the state-of-the-art commercial multi-junction EEL for LiDAR, the AR-VCSEL LiDAR provided in this application has more than double the power within a 10° FOV. Although the brightness of the AR-VCSEL in this application is still lower than that of the state-of-the-art EEL, the spectral brightness is more than doubled, which is believed to substantially improve the performance of medium- and long-range LiDARs equipped with narrow bandwidth filters. Although the EEL can reach a similar spectral brightness at a higher current, it is less valuable due to the lack of narrow bandwidth filters matching its large temperature coefficient of wavelength drift. It should be noted that the antireflective layer 41 and the light storage layer 42 are not necessarily separable.

In one embodiment of the present application, FIG. 18 is a light field intensity distribution diagram and a refraction index distribution diagram of another antireflective vertical-cavity surface-emitting laser provided in an embodiment of the present application. Referring to FIG. 18, an antireflective layer can be built into a light storage layer so that the antireflective layer and the light storage layer are integrated. The antireflective light storage cavity 40 includes: multiple first semiconductor material layers 401 and multiple second semiconductor material layers 402. The first semiconductor material layers 401 and the second semiconductor material layers 402 are arranged alternately in sequence. The number and optical thickness of the first semiconductor material layers 401 are the same as the number and optical thickness of the second semiconductor material layers 402. The refraction index of each first semiconductor material layer 401 is different from that of each second semiconductor material layer 402, and the thickness of the antireflective light storage cavity 40 is an integer multiple of half the lasing wavelength. Compared with the active region 30, the structure and phase in the antireflective light storage cavity 40 can become flexible as long as the electric field intensity in the antireflective light storage cavity 40 is enhanced. The key to such electric-field profile engineering is to guarantee that the accumulated phase shift over the whole light reservoir, that is, the optical distance between the active region 30 and the lower Bragg reflector layer 10 is a half-wave integer. The antireflective light storage cavity 40 provided in the embodiment of the present application provides great potential for engineering and tailoring the light intensity distribution in AR-VCSELs.

Please note that the AR-VCSEL design is different from a double cavity design (active-passive cavities), and the double cavity design was proposed mainly for narrow bandwidth applications. If used for low divergence purposes, the substantive drop in the electric field between the passive cavity and the active cavity not only is inefficient in lowering $\Gamma ox$, but also adversely increases the total cavity length and decreases the FSR. The AR-VCSEL design is also different from a passive cavity surface-emitting laser, In the passive cavity surface-emitting laser, a thin active layer 310 is inserted into one of the quarter-wavelength high-refraction index layers in its top DBR (the upper Bragg reflector layer 20), allowing the dielectric materials to form a passive cavity for better temperature stability or mode control. The antireflective cavity in this application is an integral cavity that combines the active region 30 and the passive region. The thickness of its multi-junction active region 30 typically well exceeds the total thickness of its top DBR. Furthermore, considering the loss mechanism of the antireflective cavity, the antireflective mirror or layers inside the light storage layer do not contribute to external mirror loss and thus cannot be considered a part of the top DBR.

Based on the above multiple embodiments, placing oxide layers (current confinement layers 320) at the standing wave electron field node positions and/or reducing the number and thickness of the oxide layers can all contribute to the minimization of $\Gamma_{ox}$ and $\Delta n_{eff}$. In one embodiment of the present application, the optical path distance between the current confinement layer 320 and the nearest standing wave light field 0-value position is set to be less than one-tenth of the lasing wavelength. The current confinement layers 320 are set at the standing wave light field 0-value positions. In order to ensure the current confinement effect of the current confinement layer 320, when the current confinement layer 320 is outside the active region 30, the current confinement layer 320 is set to be located within the range of two wavelengths along a side perpendicular to the active layer 310. The number of current confinement layers 320 is less than or equal to the number of the active layers 310 and less than or equal to the number of tunnel junctions 330 plus 1.

Additionally/alternatively, the light-emission aperture of the AR-VCSEL is located in the un-oxidized region of the oxide layer, and the thickness of the oxidized portion of the oxide layer near the outer edge of the optical aperture is set to be less than 30 nm to reduce $\Gamma_{ox}$ and $\Delta n_{eff}$. The thickness of the oxidized portion of the oxide layer near the outer edge of the optical aperture is less than 20 nm, or the thickness of the oxidized portion of the oxide layer near the outer edge of the optical aperture is less than 15 nm.

Based on the above multiple embodiments, in the direction opposite to the laser output direction, the antireflective vertical-cavity surface-emitting laser includes a dielectric layer, an electrical contact layer, a lateral current spreading layer, a p-type upper Bragg reflector layer, an active region with an oxide layer, an antireflective light storage cavity, an n-type lower Bragg reflector layer, and a substrate. Referring to FIG. 1, each of the active layers 310 includes a PIN structure, and the PIN structure includes at least one quantum well 302. The active layers 310 are connected in series through tunnel junctions 330. It can be understood that in each active layer 310, a quantum well 302 as well as an N-type semiconductor layer 303 and a P-type semiconductor layer 301 located on both sides of the quantum well 302 can be included. Each active layer 310 has at most one current confinement layer 320, specifically, the optical path distance between the tunnel junction 330 and the nearest standing wave light field node is less than one-tenth of the lasing wavelength. Optionally, the tunnel junctions 330 are located at the standing wave light field nodes. Since the tunnel junction 330 has very high doping, the doping will produce light absorption loss and reduce luminous efficiency, so placing the tunnel junctions 330 at the light field minima can minimize the light loss. In the structure of the multiple active layers 310, it is also possible to only equip one current confinement layer 320, and the current confinement layer 320 is located in the active layer 310 closest to the upper Bragg reflector layer 20.

When the active layer 310 includes one quantum well 302, the optical path distance between the quantum well 302 and the nearest standing wave light field peak position is less than one-fifth of the lasing wavelength. When the active layer 310 includes multiple quantum wells 302, the optical path distance between the overall center position of each quantum well and its nearest standing wave light field peak position is less than one-tenth of the lasing wavelength. Optionally, the overall center position of each quantum well is aligned with an electric field peak position. Because the quantum well is where the laser gain amplification is performed, the overall center position of each quantum well is aligned with a strongest position of the light field, which can achieve a greater amplification effect.

The antireflective vertical-cavity surface-emitting laser further includes: an ion implantation layer. The ion implantation layer is located on the surface of the substrate close to the n-type lower Bragg reflector layer, and the ion implantation layer is configured to enhance the electrical insulation between the substrate and the n-type lower Bragg reflector layer. Alternatively, the ion implantation layer is located at the bottom of the oxide trench, and the ion implantation layer is configured to enhance the electrical insulation between the bottom of the oxide trench and the substrate. The current confinement layer is formed by oxidizing the sidewall of the oxide trench. The implanted ions include at least one of the H ions, He ions, B ions, or O ions.

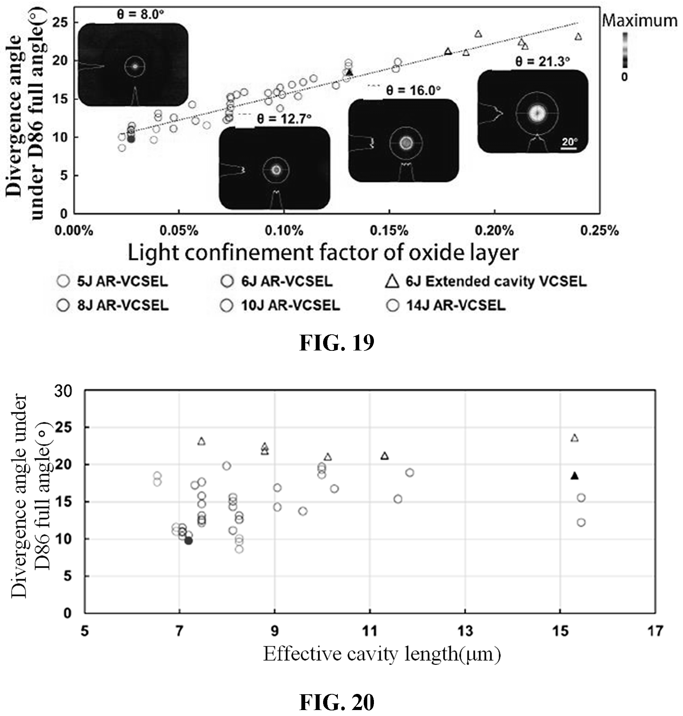

Based on the above multiple embodiments, the AR-VCSEL can achieve a low divergence angle while increasing the output optical power by increasing the number of junctions of the active layers 310. To cover a wide divergence angle range for different application purposes, in the embodiments of the present application, more than fifty AR-VCSEL and extended cavity VCSEL structures with different $\Gamma_{ox}$ were designed and experimented with. These designs include 5-, 6-, 8-,10-, and 14-junction AR-VCSEL structures, and 6-junction extended cavity VCSEL structure, fabricated into the identical 250 $\mu$m array pattern and tested under the same driving conditions of 3 ns pulses at a repetition rate of 20 kHz at room temperature, at an injection current of 10 A. The test results are shown in FIG. 19 to FIG. 21 as follows.

FIG. 19 shows the dependence of the divergence angle on the light confinement factor of the oxide layer provided in an embodiment of the present application. As shown in FIG. 19, there is a clear correlation between the divergence angle and $\Gamma_{ox}$. Almost all AR-VCSELs and extended cavity VCSELs follow the same trend line regardless of the number of junctions. The dotted trend line reveals a near-linear relationship between the divergence angle and the oxide confinement factor, and the divergence angle of the laser is positively correlated with the light confinement factor of the oxide layer. Through careful design, the AR-VCSEL provided in the embodiment of the present application achieves precise control of the divergence angle (D86) from 8° to 25°. To the best of the inventor's knowledge, this is the first time that an ultra-small divergence angle (D86) below 10° has been achieved with the single-longitudinal-mode operation for a multi-junction VCSEL array by only optimizing its epitaxial structure without any type of lens, lateral grating or two-dimensional photonic crystal structure. Circular dots represent the measured data points of 46 AR-VCSEL epitaxial designs, among which the solid circular dot represents the AR-VCSEL in FIG. 6. The triangular dots represent the measured data points of 8 extended cavity VCSEL designs, among which the solid triangular dot represents the extended cavity VCSEL in FIG. 2. The green circles, red circles, purple circles, brown circles, and blue circles represent AR-VCSELs with 5 junctions (7 designs), 6 junctions (32 designs), 8 junctions (3 designs), 10 junctions (3 designs) and 14 junction (1 design), respectively.

FIG. 20 shows the dependence of the divergence angle on the effective cavity length provided in an embodiment of the present application. As shown in FIG. 20, with the identical cavity length, the AR-VCSEL arrays consistently show lower divergence angles. It is also worth noting that the divergence angle does not form a linear relationship with the effective cavity length, as $\Gamma_{ox}$ can vary for the same effective cavity length.

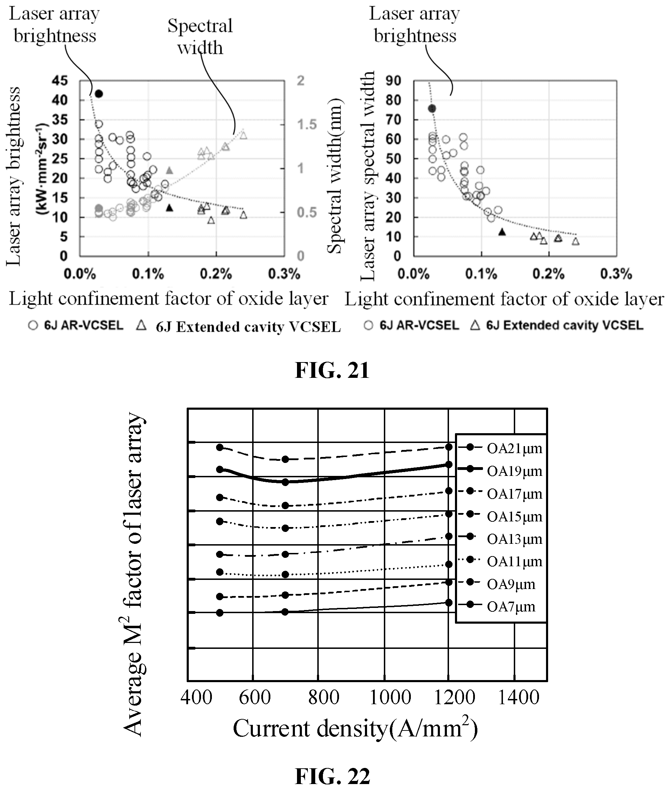

FIG. 21 shows the dependences of the laser array brightness, spectral width, and spectral brightness respectively on the light confinement factor of an oxide layer provided in an embodiment of the present application. The left figure in FIG. 21 shows curves of the dependences of the array brightness on $\Gamma_{ox}$ and curves of the dependences of the spectral width on $\Gamma_{ox}$ of the 6-junction AR-VCSEL array and the 6-junction extended cavity VCSEL array at 10 A; and the right figure in FIG. 21 shows curves of the dependences of the array spectral brightness on $\Gamma_{ox}$ of the 6-junction AR-VCSEL array and the 6-junction extended cavity VCSEL array at 10 A. The same junction number is used for a fair comparison between the AR-VCSEL array and the extended cavity VCSEL array. As can be seen from FIG. 21, the brightness of the laser is negatively correlated with the light confinement factor of the oxide layer. The spectral brightness of the laser is negatively correlated with the light confinement factor of the oxide layer. The highest brightness achieved with 6 junctions in the 250 $\mu$m diameter AR-VCSEL array according to the embodiment of the present application is about 40 kW*mm$^{-2}$sr$^{-1}$, and the highest brightness achieved for single emitters is 140 kW*mm$^{-2}$sr$^{-1}$ due to fully utilized emission area. The spectral brightness achieved in AR-VCSEL at 10 A is 75.6 kW*nm$^{-1}$mm$^{-2}$sr$^{-l}$ for arrays and 260 kW*nm$^{-1}$mm$^{-2}$sr$^{-1}$ for single emitters, a similar level as the state-of-the-art LiDAR EEL, the spectral brightness achieved in the state-of-the-art LiDAR EEL at 10 A is typically 120 kW*nm$^{-1}$mm$^{-2}$sr$^{-l}$ at a higher current and the state-of-the-art LiDAR EEL is not useful without filter wavelength-shift-matching. As a reference, the state-of-the-art VCSEL array for LiDAR in the related art has a moderate spectral brightness of only 12 kW*nm$^{-1}$mm$^{-2}$sr$^{-l}$. Considering that the number of junctions of an AR-VCSEL can be increased, while the capacity of the light storage layer can be extensively enlarged, and the emission size of the array can be shrunk, so that the spectral brightness and power of the AR-VCSEL can be increased by several times or even an order of magnitude. For example, in one embodiment of the present application, a brightness of over 100 kW*mm$^{-2}$sr$^{-l}$ has been achieved on a 100 $\mu$m square array of 6 junction AR-VCSELs (see FIG. 30). Overall, the AR-VCSELs provide high spectral brightness, high beam quality, and excellent temperature stability while remaining most cost-effective for producing higher power per unit area.

In addition to varying the number of junctions between active layers and the oxide layer light confinement factor $\Gamma_{ox}$, in one embodiment of the present application, another critical parameter is investigated: the diameter of the optical aperture (OA), that is, the diameter dimension of the light-emission aperture. Optionally, the diameter ranges from 3$\mu$m to 22$\mu$m. FIG. 22 shows the dependence of the averaged M$^2$ factor of an AR-VCSEL array with different optical apertures on the current density provided in an embodiment of the present application. Referring to FIG. 22, a series of AR-VCSEL arrays with a dimension of 250 $\mu$m are provided according to an embodiment of the present application, each of the arrays is densely populated with identical AR-VCSELs featuring OA diameters including 7 $\mu$m, 9 $\mu$m, 11 $\mu$m, 13 $\mu$m, 15 $\mu$m, 17 $\mu$m, 19 $\mu$m and 21 $\mu$m, all with the same epitaxial structure, for example, the epitaxial structure as shown in FIG. 6. Subsequently, their divergence angles were measured, and the averaged M$^2$ values in these arrays were calculated. The results show that there is a clear correlation between the diameter of the optical aperture OA and the M$^2$ value. As shown in FIG. 22, as the size of the optical aperture OA decreases, the M$^2$ value also decreases. It is worth noting that when the aperture size is reduced to 7 $\mu$m, the M$^2$ approaches a value close to 1, suggesting that the majority of emitters in the AR-VCSEL array might operate in nearly a single transverse mode lasing state.

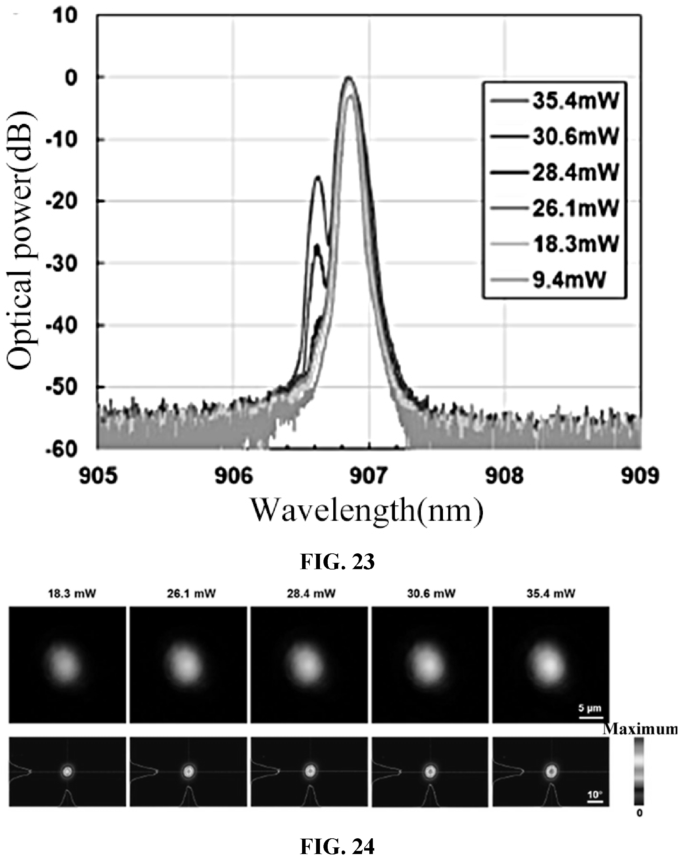

To delve deeper into the behavior of the 7 $\mu$m OA array sample and confirm the possibility of single-mode lasing, in an embodiment of the present application, a 100 ns pulse driver is used for testing. This allows a better control to the AR-VCSEL array at a lower current, facilitating the determination of the transition point between single-mode lasing and multi-mode lasing. Referring to FIG. 36, the emission of a specific emitter (AR-VCSEL) is coupled into an optical fibre (MM-Fibre) through a free-space lens numerical aperture (NA) (all other emitters in the laser array are optically completely blocked off by silver paste). FIG. 23 shows the lasing spectra of the OA 7 $\mu$m AR-VCSEL at different output powers provided in an embodiment of the present application. Referring to FIG. 23, the light output powers include 35.4 mW, 30.6 mW, 28.4 mW, 26.1 mW, 18.3 mW, and 9.4 mW. At an optical power of 28.4 mW with a current of approximately 7.8 mA (calculated by dividing the total array current by the number of emitters) and a current density of about 200 A/mm$^2$, the spectrum indicates single-mode lasing with a side mode suppression ratio (SMSR) reaching nearly 40 dB. This confirms the achievement of high-power single transverse mode lasing in the AR-VCSEL array under the 100 ns pulse condition. The 28.4 mW peak power of this individual emitter surpassed the highest power of 14 mW for multi-junction VCSEL single-mode lasing reported in the literature. It is worth noting that the 7 $\mu$m OA of the AR-VCSEL is considerably larger than the 3 $\mu$m to 4 $\mu$m typically required for traditional single-mode VCSELs without additional surface relief or complex structures.

Furthermore, FIG. 24 shows the comparison of near-field measured images and far-field measured images of a 7 $\mu$m OA AR-VCSEL at different output powers provided in an embodiment of the present application. In the embodiment of the present application, the near-field images (first row) and far-field images (second row) of the light emitted from the light-emission aperture are further detected. The light fields exhibit slightly elliptical shapes, likely attributed to the imperfect circular shape of the light-emission aperture. When analyzing the side views of the far-field intensity, their shapes closely resemble Gaussian curves. The far-field divergence angle of 9.4° for the 7 $\mu$m OA AR-VCSEL almost at the diffraction limit, a key characteristic of single-mode operation.

It is essential to acknowledge that, at this stage, this application cannot conclusively confirm the consistency of the optical mode between continuous wave (as in most previous single-mode VCSEL work) and pulse conditions (as in this work). This aspect necessitates further investigation in the future. Furthermore, it is to be noted that in AR-VCSEL arrays, as well as in regular VCSEL arrays, the light emitted by individual emitters lacks coherence with each other. Consequently, even if each emitter operates in a single mode, the light field of the entire array cannot be considered a single mode. Instead, it represents a superposition of multiple single-mode light fields.

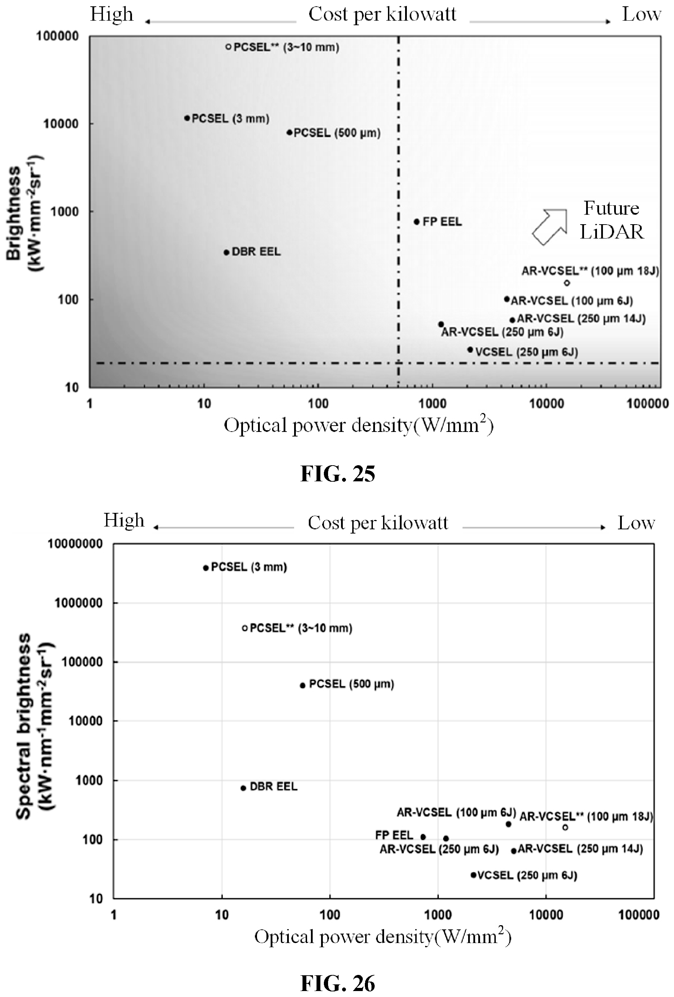

In one embodiment of the present application, the performance of the AR-VCSEL array is also compared with those of other semiconductor lasers, such as the photonic crystal surface-emitting laser (PCSEL) array, for LiDAR applications. The PCSELs recently have been considered as a potential LiDAR light source due to their extremely high brightness. However, their low power density might limit such applications. FIG. 25 shows the comparison between AR-VCSELs provided in an embodiment of the present application and other types of semiconductor lasers applied in LiDARs in terms of brightness and power per unit effective area. FIG. 25 maps the brightness versus the power per unit area of various semiconductor lasers. FIG. 26 shows the comparison between AR-VCSELs provided in an embodiment of the present application and other types of semiconductor lasers applied in LiDARs in terms of spectrum brightness and power per unit effective area. FIG. 26 maps the spectral brightness versus the power per unit area of various semiconductor lasers. The laser arrays in the lower right corners of FIG. 25 and FIG. 26 (100 $\mu$m 18-junction AR-VCSEL array, 100 $\mu$m 6-junction AR-VCSEL array, 250 $\mu$m 14-junction AR-VCSEL array, 250 $\mu$m 6-junction AR-VCSEL array) will be favored in the competition for long-distance LiDARs. FIG. 35 shows the comparison between the photoelectric characteristics of various AR-VCSEL arrays provided in the embodiments of the present application and various high-power laser arrays provided in the related art. Referring to FIG. 35, the various AR-VCSEL arrays include 250 $\mu$m 6-junction AR-VCSEL array, 100 $\mu$m 6-junction AR-VCSEL array, and 250 $\mu$m 14-junction AR-VCSEL array. The various high-power laser arrays provided in the related art include EEL arrays and PCSEL arrays. The curves of dependences of the optical power density on current density, of input electrical power on optical power within a 10° field of view, of total output power on current, and of external quantum efficiency on current of the AR-VCSEL array and other types of LiDAR semiconductor laser arrays were examined and compared. The EEL's power (current) density is calculated by the power (current) divided by the ridge area. The power density of all the surface-emitting lasers was calculated by the power divided by the total emission area.

In terms of divergence angle and brightness: for a 200 m long-range scanning LiDAR, a collimated beam with a divergence angle<0.03° is required to produce a spot size of 10 cm. PCSEL offers a divergence angle of 0.1°, and can significantly reduce the size of the collimation lens or even possibly eliminate the collimation lens for shorter distances or lower resolutions. In this sense, PCSEL has advantages of a smaller optical etendue, allowing a smaller spot size after collimation. However, there are no additional benefits when the laser spot size becomes smaller than the spatial resolution of the sensor. For today's scanning LiDAR, a brightness of 10 kW*mm$^{-2}$sr$^{-1}$ to 20 kW*mm$^{-2}$sr$^{-l}$ is sufficient to match the sensor array with a 10 $\mu$m pitch. The 30 kW*mm$^{-2}$sr$^{-1}$-60 kW*mm$^{-2}$sr$^{-l}$ AR-VCSEL light source provided in the embodiment of the present application is sufficient to match the next generation sensor array with a pitch of 6 $\mu$m or three times the current pixel resolution which may take a few years to be developed.

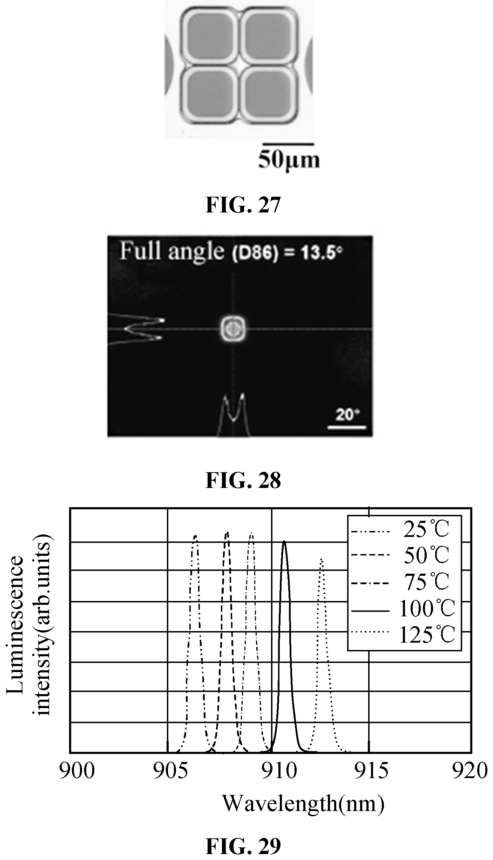

In addition, FIG. 27 is a schematic structural diagram of a square laser array consisting of four square AR-VCSELs provided in an embodiment of the present application, FIG. 28 is a schematic diagram of a far-field image of the structure shown in FIG. 27 measured at an injection current of 5.5 A, FIG. 29 is a lasing spectrum diagram of the structure shown in FIG. 27 measured at an injection current of 5.5 A being injected at different temperatures (25°C, 50°C, 75°C, 100°C, 125°C), and FIG. 30 is a graph of various photoelectric characteristic curves of the structure shown in FIG. 27, including a curve of the dependence of the optical power within the full divergence angle on the current, a curve of the dependence of the optical power within the 10° divergence angle of the laser on the current, a curve of the dependence of the power conversion efficiency on the current, a curve of the dependence of the optical power density on the current, a curve of the dependence of the brightness on the current, and a curve of the dependence of the spectral brightness on the current. Referring to FIG. 27 to FIG. 30, the 100 kW*mm$^{-2}$sr$^{-1}$ brightness from the 100 $\mu$m-sized AR-VCSEL array provided in an embodiment of the present application can cover the needs of sub 5 $\mu$m detector pixels. With more junctions, smaller areas, fewer oxide layers, and stronger light storage layers, AR-VCSELs with a brightness of 200 kW*mm$^{-2}$sr$^{-l}$ to 1000 kW*mm$^{-2}$sr$^{-l}$ are achievable to match higher resolution sensor arrays.

In terms of power density or kilowatt per chip area: the biggest advantage of AR-VCSELs over PCSELs is power density. The chip area determines the number of chips produced in a fixed-sized semiconductor substrate, such as the 6-inch GaAs substrate which is widely used for VCSEL production. If the type of substrate, epitaxial thickness and times of regrowth, layers of fabrication and complexity, and on-wafer test hours are all similar, the production cost of the whole wafers would be similar. The unit cost of the chip produced is then directly proportional to the chip area. Therefore, to reduce costs, a smaller chip size is preferred to produce the same amount of power required. Although PCSELs may increase the power density by sacrificing beam quality, as reported experimentally, PCSEL's peak power density is only 60 W/mm$^2$. AR-VCSEL and VCSEL can go beyond 1000 W/mm$^2$ easily (FIG. 25). As shown in FIG. 25, a 100 $\mu$m square-shaped 6-junction AR-VCSEL array provided in the embodiment of the present application can provide a 45 W peak power with an optical power density of 4500 W/mm$^2$.

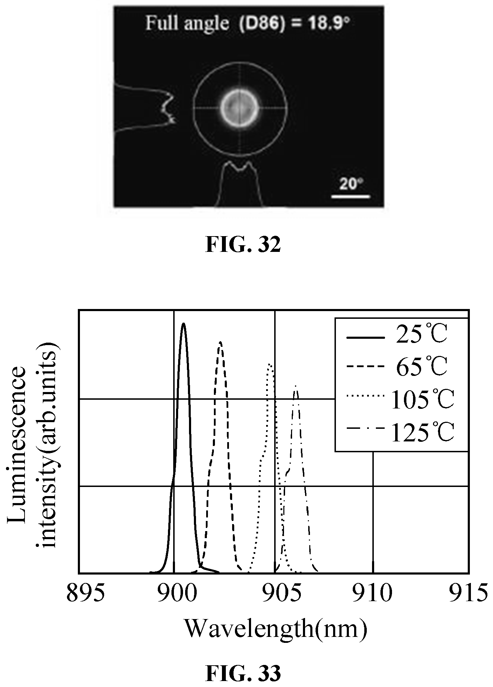

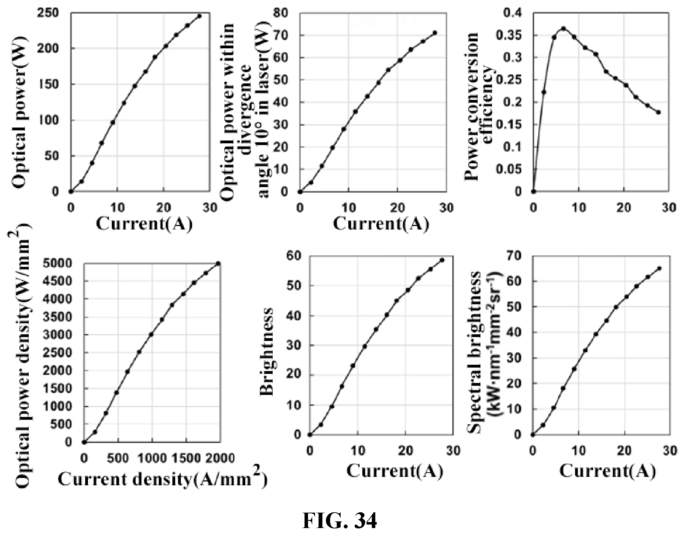

In addition, FIG. 31 is a schematic structural diagram of a hexagonal laser array consisting of 37 hexagonal AR-VCSELs provided in an embodiment of the present application, FIG. 32 is a schematic diagram of a far-field image of the structure shown in FIG. 31 measured at an injection current of 10 A, FIG. 33 is a lasing spectrum diagram of the structure shown in FIG. 31 measured at an injection current of 10 A being injected at different temperatures (25°C, 65°C, 105°C, 125°C); FIG. 34 is a graph of various photocurrent characteristic curves of the structure shown in FIG. 31, including a curve of the dependence of the optical power within the full divergence angle on the current, a curve of the dependence of the optical power within the 10° divergence angle of the laser on the current, a curve of the dependence of the power conversion efficiency on the current, a curve of the dependence of the optical power density on the current, a curve of the dependence of the brightness on the current, and a curve of the dependence of the spectral brightness on the current. Referring to FIG. 31 to FIG. 33, a 250 $\mu$m AR-VCSEL array with 14 junctions can produce 240 W peak power and 5000 W/mm$^2$ optical power density.

Based on these numbers, it can be predicted that a 100 $\mu$m square shaped 18-junction AR-VCSEL array can possibly reach 15,000 W/mm$^2$. Just considering the area usage of the semiconductor alone, AR-VCSEL costs 10 times to 100 times less than PCSEL for generating the same optical power without accounting for PCSEL's expensive lithography and regrowth process. Lasers and sensor chips each take about 20% to 40% of the total cost of a LiDAR. Under current PCSEL technology, even if the cost of the transmitting-end lens is completely eliminated (20% of LiDAR total cost), the cost savings are far less than the tenfold (conservative estimate) increase in total cost brought about by the larger chip area (2 to 4 times that of LiDAR's total cost). In the current market, aiming towards $100 in material cost for the long-distance main LiDAR requires the cost of the light source within half of it. The total power of all the light source chips in such a LiDAR is typically 5 kW. Therefore, $10 per kW is a rough cost requirement for laser chips. AR-VCSELs, VCSELs, and even EELs in the market can all more or less meet this cost requirement, while PCSEL needs some revolutionary technology to increase its power density by 10 to 100 times to be as competitive. Similar to the PCSELs, the wavelength-temperature stabilized DBR lasers can also achieve decent brightness and spectral brightness, however, their power per chip area is on the far-left side in FIG. 25, making them much more expensive and less competitive for LiDARs. Complex manufacturing, such as electron-beam lithography, nanoimprint, and epitaxial regrowth, is needed for PCSEL and DBR lasers.

In addition to LiDARs, AR-VCSELs can also be used for structured light 3D sensing due to their reduced divergence angle, improved beam quality, and minimized crosstalk between emitters. For data communication applications, AR-VCSELs can potentially realize single-transverse-mode to reduce the chromatic and modal dispersion with a larger oxide aperture than conventional single-mode VCSELs.

Furthermore, the antireflective light storage cavity 40 technology can promote other cutting-edge surface-emitting laser technologies. For example, the z-direction light reservoir in AR-VCSELs can be combined with x-y plan photonic crystals, topological cavities, or metasurface structures, to potentially realize higher output power and efficiency for these surface-emitting lasers.

In summary, an AR-VCSEL that combines an antireflective light storage cavity 40 and a multi-junction active region has a significantly reduced divergence angle, high brightness, and high spectral brightness while maintaining the single-longitudinal-mode lasing. By solely reconstructing the epitaxial layer, this unique design requires neither complex device structures nor additional manufacturing steps. With a standard low-cost VCSEL processes, an ultra-small full divergence angle of 8.0° (D86) or 4.1° (FWHM), a brightness of over 40 kW*mm$^{-2}$sr$^{-1}$ and a spectral brightness of 75.6 kW*nm$^{-1}$mm$^{-2}$sr$^{-1}$ are realized on a 250 $\mu$m 6-junction AR-VCSEL array. By applying a more compact 100 $\mu$m array, the AR-VCSEL array brightness is improved to over 100 kW*mm$^{-2}$sr$^{-1}$, and the spectral brightness is improved to over 180 kW*nm$^{-1}$mm$^{-2}$sr$^{-1}$. By increasing the number of junctions, 5000W/mm$^2$ power density is achieved with a 250 $\mu$m 14-junction AR-VCSEL array. By varying the oxidation aperture sizes, 28.4 mW high-power single transverse mode lasing was realized in a 7um diameter 6-junction AR-VCSEL single emitter. To the best of the applicant's knowledge, these are the best performances among published multi-junction VCSELs. Further complemented by scalable high output power, near-circular symmetrical beams, and a filter-matchable wavelength drift with temperature, AR-VCSELs exhibit more advantages over the rival EELs. In this application, AR-VCSELs are also compared with the PCSELs in various aspects, showing that the power density, which is the key to a low-cost LiDAR, is the most difficult challenge for PCSELs to overcome. Overall, AR-VCSELs exhibit well-balanced performance in various requirements by LiDARs. Particularly, for high-power and low-cost scanning LiDARs that require 16° (D86) divergence angle or below, AR-VCSEL is the best solution available.

The photoelectric characteristics of all VCSEL/ARVCSEL arrays were tested under short pulse conditions with a pulse width of 3 ns and a frequency of 20 kHz at a test environment temperature of room temperature. The driver circuit, as shown in FIG. 37, includes a capacitor charging and discharging circuit 1011 and a capacitor charging and discharging driver circuit 1013. The capacitor charging and discharging circuit 1011 includes: a charging resistor R1, a charging and discharging capacitor C1, and a power supply 1012. A negative electrode of the power supply 1012 is grounded, a positive electrode of the power supply 1012 is electrically connected to one end of the charging resistor R1, the other end of the charging resistor R1 is electrically connected to one end of the charging and discharging capacitor C1, and the other end of the charging and discharging capacitor C1 is grounded. The end of the charging resistor R1 connected to the charging and discharging capacitor C1 is further electrically connected to one end of the light source 102. The capacitor charging and discharging driver circuit 1013 includes: a switch tube Q1 and a switch tube driver circuit 1014. One end of the switch tube driver circuit 1014 is grounded, and the other end is electrically connected to a first end of the switch tube Q1, a second end of the switch tube Q1 is grounded, and a third end of the switch tube Q1 is electrically connected to the other end of the light source 102.

The photoluminescence spectrum was measured by Nanometrics RPMBlue system with an OBIS LS 532 nm CW laser having an optical power of 20 mW and a spot size of 20 $\mu$m at room temperature. Far-field patterns were collected by an Ophir L11059 Beam Profiling Camera at an operation current of 10 A. The light output power was measured by a Newport 819D-SL-3.3 Integrating Sphere. Lasing spectra were collected by an Ocean Insight HR4Pro spectrometer at an operation current of 10 A with a resolution of 0.2 nm. Single-mode lasing spectra were collected by an Anritsu MS9740A spectrometer with a resolution of 0.07 nm. The two-dimensional electric field intensity simulation was conducted using Ansys Lumerical FDTD solutions. The full vectorial simulation was conducted using perfectly matched layer (PML) boundary conditions, and final simulation results were obtained with an auto-shutoff minimum of 1E-5 and an auto-shutoff maximum of 1E5. Simulations of both with gain and without gain in the active layer were conducted. The simulated normalized E(z) field intensity profiles with gain and without gain were compared with a difference of less than 0.1%, thereby confirming a stable static distribution.

An antireflective vertical-cavity surface-emitting laser chip is further provided according to embodiments of the present application, which includes at least one laser array; the laser array includes multiple antireflective vertical-cavity surface-emitting lasers of any embodiment of the present application. The laser array is a regularly arranged array, or a randomly arranged array, or an array with multiple addressable sub-arrays.

Optionally, the dimension of the laser array is less than or equal to 250 $\mu$m; the brightness of the laser array is greater than or equal to 40 kw*mm$^{-2}$sr$^{-1}$, and the spectral brightness is greater than or equal to 75.6 kW*nm$^{-1}$mm$^{-2}$sr$^{-l}$.

Optionally, when the number of junctions of the active layers in the antireflective vertical-cavity surface-emitting laser is greater than or equal to fourteen junctions, the optical power density of the antireflective vertical-cavity surface-emitting laser chip is greater than or equal to 5000W/mm$^2$.

It is to be noted that the pattern of the laser array in the embodiments of the present application can be a rectangular, circular, regular hexagonal, or other patterns. For a rectangular laser array, its dimension is the length or width. For a circular laser array, its dimension is the diameter. For a regular hexagonal laser array, its dimension is the diameter of the inscribed circle.

It should be understood that the various forms of the process shown above can be used to reorder, add, or delete steps. For example, the multiple steps recorded in this application can be executed in parallel, sequentially, or in different orders, as long as the desired results of the technical solution of the present application can be achieved, which is not limited herein.

## Claims

1. An antireflective vertical-cavity surface-emitting laser, comprising:

 a lower Bragg reflector layer;
 an active region, located on one side of the lower Bragg reflector layer, wherein the active region comprises at least five active layers and tunnel junctions between the active layers; a current confinement layer is provided in the active region or near an outer side of the active region;

an upper Bragg reflector layer, located on a side of the active region away from the lower Bragg reflector layer; and

an antireflective light storage cavity, located at at least one of a region between the lower Bragg reflector layer and the active region, or a region between the upper Bragg reflector layer and the active region,

wherein the antireflective light storage cavity is configured to increase a peak light field intensity of the antireflective light storage cavity to be higher than the peak light field intensity of the active region, and to store light field energy, and

the antireflective vertical-cavity surface-emitting laser is configured to operate under conditions of an injection current density greater than 10 kA/cm$^2$, a slope efficiency greater than 4 W/A, and a far-field divergence angle less than or equal to 19°.

2. The antireflective vertical-cavity surface-emitting laser according to claim 1, wherein,

the current confinement layer comprises an oxide layer, the oxide layer is epitaxially grown high-Al-content AlGaAs, and an oxidized region on an outer side of the oxide layer forms an insulating aluminum oxide film layer; wherein an un-oxidized region of the oxide layer forms an effective current-injected light-emission region; an optical path distance between the current confinement layer and a nearest standing wave light field 0-value position is less than one-tenth of a lasing wavelength; when the current confinement layer is outside the active region, the current confinement layer is located in a range of two wavelengths along a side perpendicular to the active layers; and a number of current confinement layers is less than or equal to a number of the active layers and less than or equal to a number of tunnel junctions plus 1.

3. The antireflective vertical-cavity surface-emitting laser according to claim 2, further comprising: a light-emission aperture located in the un-oxidized region of the oxide layer, wherein a thickness of an oxidized portion of the oxide layer near an outer edge of the light-emission aperture is less than 30 nm.

4. The antireflective vertical-cavity surface-emitting laser according to claim 3, wherein a light confinement factor of the oxide layer is less than 0.16%.

5. The antireflective vertical-cavity surface-emitting laser according to claim 1, wherein the active layer comprises a PIN structure, the PIN structure comprises at least one quantum well; and the active layers are connected in series through the tunnel junctions.

6. The antireflective vertical-cavity surface-emitting laser according to claim 5, wherein, when the active layer comprises one quantum well, an optical path distance between the quantum well and a nearest standing wave light field peak position is less than one-fifth of a lasing wavelength; and when the active layer comprises a plurality of quantum wells, an optical path distance between an overall center position of each quantum well in the plurality of quantum wells and a nearest standing wave light field peak position is less than one-tenth of the lasing wavelength.

7. The antireflective vertical-cavity surface-emitting laser according to claim 1, wherein, in a direction opposite to a laser output direction, the antireflective vertical-cavity surface-emitting laser comprises a dielectric layer, an electrical contact layer, a lateral current spreading layer, a p-type upper Bragg reflector layer, an active region having an oxide layer, the antireflective light storage cavity, an n-type lower Bragg reflector layer and a substrate in sequence.

8. The antireflective vertical-cavity surface-emitting laser according to claim 7, further comprising: an ion implantation layer; wherein,

the ion implantation layer is located on a surface of the substrate close to the n-type lower Bragg reflector layer, and the ion implantation layer is configured to enhance electrical insulation between the substrate and the n-type lower Bragg reflector layer; or

the ion implantation layer is located at a bottom of the oxide trench, and the ion implantation layer is configured to enhance electrical insulation between the bottom of the oxide trench and the substrate, and the current confinement layer is formed based on oxidizing a sidewall of the oxide trench,

wherein ions implanted to the ion implantation layer comprise at least one of H ions, He ions, B ions or O ions.

9. The antireflective vertical-cavity surface-emitting laser according to claim 1, wherein peak electric field intensities of different active layers are same or different; a maximum peak electric field intensity in the active region is less than a maximum peak electric field intensity in the antireflective light storage cavity.

10. The antireflective vertical-cavity surface-emitting laser according to any one of claims 1 to 9, wherein the antireflective light storage cavity comprises: an antireflective layer and a light storage layer; the antireflective layer is located between the light storage layer and the active region; the antireflective layer is configured to increase a peak light field intensity of the light storage layer therein to be higher than a peak light field intensity of the active region; and the light storage layer is configured to store light field energy;
wherein, a thickness of the light storage layer is an odd multiple of half the lasing wavelength; in a direction from the active region to the antireflective light storage cavity, the antireflective layer comprises at least one of the following: a first antireflective interface between the light storage layer and the active region located at an interface from low refraction index to high refraction index, and a second antireflective interface between the light storage layer and the active region located at an interface from high refraction index to low refraction index; an optical path distance between the first antireflective interface and a nearest standing wave light field antinode position is less than one-tenth of the lasing wavelength; or an optical path distance between the second antireflective interface and a nearest standing wave light field node position is less than one-tenth of the lasing wavelength.

11. The antireflective vertical-cavity surface-emitting laser according to any one of claims 1 to 9, wherein the antireflective light storage cavity comprises:

a plurality of first semiconductor material layers and a plurality of second semiconductor material layers, wherein the plurality of first semiconductor material layers and the plurality of second semiconductor material layers are arranged alternately in sequence;
a number and optical thickness of the first semiconductor material layers are same as a number and optical thickness of the second semiconductor material layers; a refraction index of the first semiconductor material layer is different from a refraction index of the second semiconductor material layer; and a distance between the active region and the Bragg reflector layer adjacent to the antireflective light storage cavity is an integer multiple of half the lasing wavelength.

12. The antireflective vertical-cavity surface-emitting laser according to claim 10, wherein a plurality of antireflective interfaces are arranged between the active region and the light storage layer, to allow an electric field intensity from the active region to the light storage layer to gradually increase.

13. An antireflective vertical-cavity surface-emitting laser chip, comprising at least one laser array, wherein the laser array comprises a plurality of antireflective vertical-cavity surface-emitting lasers according to any one of claims 1 to 12; the laser array is a regularly arranged array, or a randomly arranged array, or an array with a plurality of addressable sub-arrays.

**FIG. 1**

**FIG. 2**

Full divergence angle(D86)=18.5°

**FIG. 3**

**FIG. 4**

d

**FIG. 5**

**FIG. 6**

# Full divergence angle(D86)=9.7°

**FIG. 7**

**FIG. 8**

**FIG. 9**

**FIG. 10**

**FIG. 11**

**FIG. 12**

Refraction index

λ=905nm

N-DBR    10.5λ    P-DBR(with,3/4λ spacer)

3/4 λ

Electric field intensity distribution

Distance(μm)

**FIG. 13**

Refraction index

λ=905nm

N-DBR    10.5λ    P-DBR (with,11¾λ spacer)

11¾λ

Electric field intensity distribution

Distance(μm)

**FIG. 14**

**FIG. 15**

**FIG. 16**

**FIG. 17**

**FIG. 18**

**FIG. 19**

**FIG. 20**

FIG. 21

FIG. 22

**FIG. 23**

**FIG. 24**

**FIG. 25**

**FIG. 26**

**FIG. 27**

Full angle (D86) = 13.5°

20°

**FIG. 28**

**FIG. 29**

**FIG. 30**

**FIG. 31**

**FIG. 32**

**FIG. 33**

FIG. 34

## FIG. 35

Legend:
- AR-VCSEL 9.7° (250 μm 6J)
- AR-VCSEL 13.5° (100 μm 6J)
- AR-VCSEL 18.9° (250 μm 14J)
- Extended cavity VCSEL 18.5°
- EEL
- PCSEL
- PCSEL

## FIG. 36

AR-VCSEL — NA 0.3 — NA 0.25 — MM-Fibre

## FIG. 37

## INTERNATIONAL SEARCH REPORT

| International application No. |
| --- |
| **PCT/CN2024/119571** |

| A. | CLASSIFICATION OF SUBJECT MATTER |
| --- | --- |

H01S5/183(2006.01)i

According to International Patent Classification (IPC) or to both national classification and IPC

| B. | FIELDS SEARCHED |
| --- | --- |

Minimum documentation searched (classification system followed by classification symbols)

IPC: H01S

Documentation searched other than minimum documentation to the extent that such documents are included in the fields searched

Electronic data base consulted during the international search (name of data base and, where practicable, search terms used)

CNABS, CNTXT, DWPI, CNKI: 常州纵慧芯光半导体科技有限公司, 垂直腔面发射激光器, 有源区, 增透层, 存储, 储光层, 注入电流密度, 斜率效率, 远场发散角, VCSEL, active w layer, antireflection w layer, light w storage w layer, injection w current w density, oblique w efficiency, divergence w angle

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| PX | CN 118380858 A (VERTILITE INC.) 23 July 2024 (2024-07-23)<br>description, paragraphs [0070]-[0142], and figures 1-37 | 1-13 |
| A | CN 115882334 A (VERTILITE INC.) 31 March 2023 (2023-03-31)<br>description, paragraphs [0067]-[0125], and figure 15 | 1-13 |
| A | CN 113823995 A (VERTILITE INC.) 21 December 2021 (2021-12-21)<br>entire document | 1-13 |
| A | CN 110932092 A (CHANGCHUN ACE PHOTONICS CO., LTD.) 27 March 2020<br>(2020-03-27)<br>entire document | 1-13 |
| A | CN 116316062 A (XIAMEN WAFERTOP TECHNOLOGY CO., LTD.) 23 June 2023<br>(2023-06-23)<br>entire document | 1-13 |
| A | US 2021273412 A1 (UNM RAINFOREST INNOVATIONS) 02 September 2021<br>(2021-09-02)<br>entire document | 1-13 |

☐ Further documents are listed in the continuation of Box C.  ☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **21 November 2024** | **02 December 2024** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/119571**

| Patent document cited in search report | | | Publication date (day/month/year) | Patent family member(s) | | | Publication date (day/month/year) |
|---|---|---|---|---|---|---|---|
| CN | 118380858 | A | 23 July 2024 | None | | | |
| CN | 115882334 | A | 31 March 2023 | WO | 2023050739 | A1 | 06 April 2023 |
| | | | | KR | 20230048048 | A | 10 April 2023 |
| | | | | TW | 805428 | B1 | 11 June 2023 |
| | | | | EP | 4207518 | A1 | 05 July 2023 |
| | | | | JP | 2023547012 | W | 09 November 2023 |
| | | | | JP | 7473272 | B2 | 23 April 2024 |
| | | | | CN | 115882334 | B | 12 December 2023 |
| | | | | US | 2024266804 | A1 | 08 August 2024 |
| | | | | GB | 2616124 | A | 30 August 2023 |
| CN | 113823995 | A | 21 December 2021 | None | | | |
| CN | 110932092 | A | 27 March 2020 | None | | | |
| CN | 116316062 | A | 23 June 2023 | None | | | |
| US | 2021273412 | A1 | 02 September 2021 | None | | | |

Form PCT/ISA/210 (patent family annex) (July 2022)

**REFERENCES CITED IN THE DESCRIPTION**

**Patent documents cited in the description**

- US 63607776

- CN 202410506933